# EUROPÄISCHE PATENTANMELDUNG

(11) **EP 4 510 790 A1**
(43) Veröffentlichungstag der Anmeldung: **19.02.2025**
(21) Anmeldenummer: 23192040.6
(22) Anmeldetag: 17.08.2023
(51) Int. Cl.: H05K 7/20

(54) **ANORDNUNG ZUM KÜHLEN EINES ELEKTRONISCHEN GERÄTS**

(71) Anmelder: Institut Für Luft- Und Kältetechnik gGmbh, 01309 Dresden (DE)
(72) Erfinder: Burandt, Bodo, 01309 Dresden (DE); Safarik, Mathias, 01309 Dresden (DE)
(74) Vertreter: Lippert Stachow Patentanwälte Rechtsanwälte Partnerschaft mbB

(57) **Zusammenfassung**

Die Erfindung betrifft eine Kühlanordnung zum Kühlen und Abführen der Betriebswärme von elektrisch und/oder elektronisch betriebenen Komponenten oder Baugruppen dieser Komponenten eines Computersystems mit einem Kühlkreislauf (1.1) für ein Einphasen-Kühlsystem oder mit einem Kühlkreislauf (1.2) für ein Zweiphasenkühlsystem mit einer Kühlflüssigkeit bzw. einem Kühlmittel als Kühlmedium, wobei im Betrieb der Kühlanordnung mittels eines ersten Vakuumbehälters ein Betriebsdruck (p1) im Kühlkreislauf (1.1, 1.2) erzeugt wird, der kleiner als der atmosphärische Druck ist.

Es wird vorgeschlagen, dass an dem Kühlkreislauf (1.1, 1.2) ein Leitungsabzweig (11) angeschlossen ist, welcher eine Steigleitung (12), in welcher eine Flüssigkeitssäule des Kühlmediums ausgebildet ist, oder ein steuerbares Absperrventil (17) aufweist, und das einzige Ende des Leitungsabzweigs (11) mit einem zweiten Vakuumbehälter (VB2) verbunden ist, wobei der Behälterdruck (p2) des zweiten Vakuumbehälters (VB2) zumindest gleich groß, vorzugsweise kleiner als der Betriebsdruck p1 im Kühlkreislauf (1.1, 1.2) ist.

## Beschreibung

Die Erfindung betrifft eine Kühlanordnung zum Kühlen und Abführen der Betriebswärme von elektrisch und/oder elektronisch betriebenen Komponenten oder Baugruppen dieser Komponenten eines Computersystems.

Derartige elektrisch und/oder elektronisch betriebene Komponenten oder Baugruppen dieser Komponenten eines Computersystems, wie z.B. eine Zentraleinheit (Central Processing Unit -CPU) oder eine Graphikverarbeitungseinheit (graphics processing unit -GPU) oder ein Rack von mehreren CPUs /GPUs als Hauptprozessor(en) eines leistungsstarken Computers oder Servers, wie sie in Rechenzentrum verwendet werden, können während ihres Betriebes erheblich viel Betriebswärme mit einer Wärmeleistung von mehreren Kilowatt erzeugen Diese Betriebswärme muss abgeführt werden, um die Prozessoren des Computersystems vor zu hohen Temperaturen zu schützen und deren Funktionssicherheit zu gewährleisten.

Der gegenwärtige Trend zu immer höhere Rechenleistung von Computern bzw. Servern verlangt eine thermisch effiziente Kühlanordnung zur Abführung der Betriebswärme der Computersysteme
Neben Kühlanordnungen, die mit Luft als Wärmeübertragungs- bzw. Kühlmedium betrieben sind, haben Kühlanordnungen mit einem fluiden Kühlmedium, wie z.B. Wasser oder einer anderen Kühlflüssigkeit, aufgrund ihre höheren Wärmekapazität gegenüber Luft eine höhere thermische Effizienz.

Eine noch bessere Effizient weisen Kühlanordnungen auf (so genannte Zweiphasen-Kühlsysteme), welche Kühlmedien unter Nutzung des temperatur- und druckabhängigen Phasenübergangs durch Verdampfung und Kondensation nutzen, wie z.B. Wasser, oder andere bekannte Kältemittel, wie R134a und R513A.

Problematisch an den mit fluiden Kühlmedien arbeitenden Kühlanordnungen ist die Gefahr von Undichtigkeiten, da es bei einer Leckage zu einem unerwünschten Flüssigkeitsaustritt kommen kann, und die austretende Flüssigkeit mit den Komponenten oder Baugruppen der Computersysteme in Kontakt kommen und zu deren Zerstörung führen kann.

Zur Minderung des Problems sind Kühlanordnungen bekannt, die einen Unterdruck, das heißt einen geringeren absoluten Druck gegenüber dem atmosphärischen Druck der Umgebung, im Kühlkreislauf des Kühlmediums erzeugen und aufrechterhalten, so dass bei einer Leckage zunächst Umgebungsluft in den Kühlkreislaufeintritt und unter allmählichen Druckausgleich mit dem Umgebungsdruck der Austritt von Kühlmedium verzögert wird.

Eine derartige Kühlanordnung und ein Verfahren zu deren Nutzung ist aus der US 2012/0180979 A1 und US 2018/0035569 A1 bekannt.

Die Kühlflüssigkeit wird mittels einer Leitungsinstallation mit angeschlossener Umwälzpumpe in einem Kühlkreislauf in Strömungsrichtung durch einen ersten Wärmeübertrager (CPU-Wärmetauscher), einem Vakuumbehälter mit angeschlossener Vakuumpumpe und einem zweiten Wärmeübertrager (offener Kühlturm) bei einem Unterdruck unter dem Umgebungsdruck gefördert. Die Kühlflüssigkeit strömt zur Kühlung einer elektrischen/elektronischen Komponente (CPU) durch den CPU-Wärmetauscher und nimmt dabei einen Teil der Betriebswärme von dieser Komponente auf. Es können mehrere in Reihe und/oder parallel geschaltete CPU-Wärmetauscher für die Kühlung mehrere elektrischer/elektronischer Bauteil vorgesehen sein. Im offenen Kühlturm wird die Kühlflüssigkeit bei Umgebungsdruck abgekühlt, wobei die Wärme an die Umgebungsluft abgegeben wird.

Der gesamte Kühlkreislauf ist soweit mit Kühlflüssigkeit gefüllt, dass während des Betriebes der Kühlanordnung im Vakuumbehälter ein Füllstand an Kühlflüssigkeit mit einem verbleibenden Gasraum erzeugt ist, dessen Druck während des Betriebes der Kühlanordnung durch die Vakuumpumpe soweit abgesenkt und gehalten ist, dass dieser anhaltend unter dem Umgebungsdruck liegt.

In einer alternativen Ausführungsform ohne Umwälzpumpe wird das Förder- und Druckhaltesystem des Kühlkreislaufes mittels zwei parallel geschalteten Druckkammern mit je einer parallel angeschlossenen Vakuumpumpe und Druckluftpumpe realisiert, wobei durch die periodische Änderung des Druckes in den Druckkammern unter Zuhilfenahme einer umfangreichen Ventilsteuerung die Druckkammern wechselseitig alternierend mit Kühlflüssigkeit befüllt und wieder entleert werden. Dieses Förder- und Druckhaltesystem soll u.a. eine sichere drucktechnische Trennung zu dem gegenüber dem Umgebungsdruck offenen Kühlturm realisieren.

Durch den vakuumunterstützten subatmosphärischen Druck im Kühlkreislauf soll ein Wasseraustritt aus dem System bei einer Leckage verhindert werden.

Dieses ist jedoch nur bedingt möglich. So kann nur dann keine Kühlflüssigkeit austreten, solange die Leckage kleiner ist als die Saugleistung der eingesetzten Vakuumpumpe.

Bereits bei etwas größeren Leckagen, die (Luft)-Leck-Volumenströme durch Lufteintritt über das Leck erzeugen, die weit größer als die Saugleistung der Vakuumpumpe sind, kann der Druck im Kühlkreislauf trotz Betrieb der Vakuumpumpe über eine kurze Zeit bis zum Druckausgleich mit dem Umgebungsdruck ansteigen und dabei Kühlflüssigkeit nach und nach in großen Mengen austreten (Havariefall), was in derartiger Kühlanordnung zur schädigenden Gefahr für das zu kühlende Computersystem wird. In Abhängigkeit von der Saugleistung der Vakuumpumpe und der Leckage-Größe kann dies sehr schnell passieren oder sich über längere Zeit hinziehen.

Bereits bei einem größeren Leck von 3 mm Durchmesser, wie es beispielsweise beim Ein- oder Abreißen eines Verbindungsschlauches auftreten kann, ergibt sich ein (Luft)-Leck-Volumenstrom von ca. 150 l/min, der durch die bekannten Ausführungen der Kühlanordnungen nicht oder nicht dauerhaft aufgefangen werden kann.

Der Erfindung liegt die Aufgabe zugrunde, die Zuverlässigkeit und Betriebssicherheit der bekannten Kühlanordnung zu verbessern, insbesondere das Austreten von Kühlflüssigkeit in das zu kühlenden Computersystem auch bei grö-ßeren Leckagen zuverlässig zu verhindern und damit leckagebedingte Schäden des Computersystems sicher zu vermeiden.

Mit der Kühlanordnung, welche eine zuverlässige Verhinderung des Austretens von Kühlflüssigkeit im Leckagefall gewährleistet, kann ein gegenwärtig wesentliches Hemmnis für einen breiteren Einsatz der umweltfreundlichen und effizienten Flüssigkeitskühlung beseitigen und deren Akzeptanz bei Anwendern, beispielsweise bei den Betreibern von Rechenzentren, deutlich erhöht werden.

Die Aufgabe wird erfindungsgemäß durch eine Kühlanordnung mit den Merkmalen des Patentanspruches 1 oder 2 und durch ein Verfahren zum Betrieb dieser Kühlanordnung nach Anspruch 12 gelöst.

Zur Lösung dieser Aufgabe ist erfindungsgemäß ein erster und ein zweiter Vakuumbehälter vorgesehen, wobei der erste Vakuumbehälter in einem geschlossenen Kühlkreislauf eingebunden ist, welcher eine Kühlflüssigkeit, beispielsweise Wasser, als Kühlmedium enthält, und der zweite Vakuumbehälter über eine Steigleitung, auch als Siphonleitung bezeichnet, mit dem Kühlkreislauf kommuniziert.

Der Kühlkreislauf umfasst zumindest die nachfolgend angeführten Funktionselemente und eine umlaufend ausgebildete Leitungsinstallation, welche die Funktionselemente des Kühlkreislaufes miteinander zu einem geschlossenen Kreislauf verbindet.

Eine Umwälzpumpe fördert die in dem geschlossenen Kühlkreislauf befindliche Kühlflüssigkeit umlaufend um, wobei diese in Strömungsrichtung beispielsweise zunächst durch einen Entlade-Wärmeübertrager gefördert werden kann, in welchem die in der Kühlflüssigkeit geladene, aus dem Computersystem aufgenommenen Wärme an ein externes fluides oder gasförmiges Wärmeübertragungsmedium, wie z.B. Wasser bzw. Luft abgegeben wird und dabei die Kühlflüssigkeit abgekühlt wird.

Danach kann die Kühlflüssigkeit beispielsweise durch einen oder mehrere Belade-Wärmeübertrager strömen, in welchen Betriebswärme aus einem oder mehreren elektrisch und/oder elektronisch betriebenen Komponenten des zu kühlenden Computersystems (z.B. CPUs /GPUs) an die thermisch kältere Kühlflüssigkeit abgegeben wird, während dessen sich die Kühlflüssigkeit erwärmt.

Der oder die Belade-Wärmetauscher kann /können für die Übertragung der Betriebswärme z.B. einen oder mehrere an je einer CPU und / oder GPU angebrachte Kühlkörper aufweisen und kann / können derart gestaltet sein, dass die Kühlkörper innerhalb eines Belade-Wärmetauschers in Reihe und/oder parallel geschaltet von der Kühlflüssigkeit durchströmt werden können.

Insbesondere für eine Parallelschaltung der Kühlkörper im Belade-Wärmetauscher können Verteil- und Sammel-Kanäle vorgesehen sein.

Anschließend kann die erwärmte Kühlflüssigkeit über eine Zulauföffnung in den ersten Vakuumbehälter gefördert werden, von wo es über eine Ablauföffnung des ersten Vakuumbehälters von der Umwälzpumpe wieder angesaugt wird.

Abweichend zur vorbeschriebenen Reihenfolge der Funktionselemente des Kühlkreislaufs in Strömungsrichtung der Kühlflüssigkeit ist auch eine andere Anordnung bzw. Reihenfolge der Funktionselemente des Kühlkreislaufs denkbar.

Diese Funktionselemente (umlaufende Leitungsinstallation, Be- und Entlade-Wärmetauscher, erster Vakuumbehälter und Umwälzpumpe) sind die für den regulären Betrieb (Regelbetrieb) der Kühlanordnung zum Kühlen und Abführen der Betriebswärme aus einem Computersystem mindestens notwendigen Komponenten des Kühlkreislaufes; es können weitere Komponenten wie Druck- und/oder Temperaturmessfühler, bzw. Druck- und/oder Temperaturregler vorgesehen sein.

Der Kühlkreislauf ist soweit gefüllt, dass sowohl im Betriebsstillstand (Betriebsruhe der Kühlanordnung) als auch im regulären Betrieb (Regelbetrieb) der Kühlanordnung zumindest der erste Vakuumbehälter nicht vollständig gefüllt ist. Es verbleibt im ersten Vakuumbehälter stets ein Gasraum über einem Füllstands-Niveau der Kühlflüssigkeit, der für die Erzeugung und Haltung eines gewünschten Unterdrucks im Kühlkreislauf der Kühlanordnung benötigt wird.

Das maximale Füllstands-Niveau im ersten Vakuumbehälter stellt sich im Betriebsstillstand der Kühlanordnung ein, also bei eingestelltem Pumpenbetrieb der Umwälzpumpe unter gehaltenem Unterdruck im Kühlkreislauf.

Das maximale Füllstands-Niveau entspricht dem entsprechend der enthaltenen Füllmenge der Kühlflüssigkeit vorbestimmten, geodätisch Füllstands-Niveau der gesamten Kühlanordnung bei druckausgeglichenem Betriebsstillstand (Ruhe-Füllstands-Niveau). Teile der Leitungsinstallation und Funktionselemente der Kühlanordnung, die entsprechend der Anlagenauslegung oberhalb des Ruhe-Füllstands-Niveaus angeordnet sind, wie z.B. die Anschlussleitung an den ersten Vakuumbehälter und/oder gegebenenfalls einzelne oder alle Kühlkörper des Belade-Wärmeübertragers, können daher bei Betriebsstillstand von Kühlflüssigkeit entleert sein.

Mit anderen Worten wird das maximale Füllstands-Niveau des ersten Vakuumbehälters entsprechend dem Ruhe-Füllstands-Niveau der Kühlanordnung durch den Füllvorgang mit entsprechender Kühlflüssigkeitsmenge vor Betriebsbeginn der Kühlanordnung bestimmt.

Dabei wird die Füllmenge an Kühlflüssigkeit so bestimmt, dass sich ein maximales Füllstands-Niveau (Ruhe-Füllstands-Niveau) im ersten Vakuumbehälter einstellt, bei dem ein derart großer Gasraum über einem Füllstands-Niveau der Kühlflüssigkeit verbleibt, welcher zur (Unter-)Druckhaltung in der Kühlanordnung benötigt wird.

Im Regelbetrieb der Kühlanordnung, bei dem sich in Zusammenwirken mit dem Pumpendruck der Umwälzpumpe ein Saugdruck im ersten Vakuumbehälter einstellt, ist ein entsprechend minimales Füllstands-Niveau der Kühlflüssigkeit im ersten Vakuumbehälter bewirkt (Regel-Füllstands-Niveau). Dabei sinkt das Füllstands-Niveau der Kühlflüssigkeit im ersten Vakuumbehälter auf ein Regel-Füllstands-Niveau ab, welches in Differenz zum maximalen Füllstands-Niveau dem fluid-beaufschlagbaren Inhalt der über dem Ruhe-Füllstands-Niveau gelegenen Teile der Leitungsinstallation und Funktionselemente der Kühlanordnung entspricht, die nunmehr mit der umlaufenden Kühlflüssigkeit gefüllt sind.

Oberhalb des maximalen Füllstands-Niveaus der Kühlflüssigkeit ist an dem ersten Vakuumbehälter eine Vakuumpumpe, beispielsweise eine Membranvakuumpumpe, angeschlossen, um durch Absaugung von Gasen aus dem Kühlkreislauf den gewünschten Unterdruck in der Kühlanordnung erzeugen und halten zu können (Druckhaltung).

Grundsätzlich wäre für die Funktion der Kühlanordnung der ersten Vakuumbehälter als ein vorevakuierten Vakuumbehälter (also ohne Anschluss der Vakuumpumpe) denkbar, was jedoch nur bei Idealbedingungen, also bei einem praktisch kaum realisierbaren, absolut dichten System, machbar erscheint.

Der Betriebsdruck im Kühlkreislauf kann im regulären Betrieb der Kühlanordnung mittels der Druckhaltung durch die Vakuumpumpe oder den vorevakuierten Vakuumbehälter soweit in einen subatmosphärischen Unterdruckbereich abgesenkt werden, dass dieser - im Zusammenwirken mit dem Pumpendruck der Umwälzpumpe - deutlich unter dem Umgebungsdruck (auch als atmosphärische Druck der Umgebungsluft bezeichnet) liegt, jedoch höher als der Sättigungsdampfdruck der Kühlflüssigkeit während des Regelbetriebes der Kühlanordnung ist.

Der Sättigungsdampfdruck der Kühlflüssigkeit ist der Druck, bei dem ein Phasenwechsel der Kühlflüssigkeit in den gasförmigen Zustand (Verdampfung) erfolgt, wobei der Sättigungsdampfdruck abhängig von der Betriebstemperatur der Kühlflüssigkeit ist.

Ein derartiger Phasenwechsel ist in dem hier beschriebenen Einphasen-Kühlsystem der Kühlanordnung, also dem Betrieb ohne Phasenwechsel / Verdampfung der Kühlflüssigkeit, zu vermeiden.

Bei einer Verdampfung oder Teilverdampfung der Kühlflüssigkeit entsteht ein sehr großes Dampfvolumen, für welches die Leitungsinstallationen und Wärmeübertrager des Einphasen-Kühlsystems nicht ausgelegt sind, was daher zu Betriebsstörungen im Kühlkreislauf und zum Ausfall der Kühlanordnung führen kann.

Damit ist der einzuhaltende Druckbereich des Betriebsdruckes der Kühlflüssigkeit außerhalb der Dampfphase in Abhängigkeit der Betriebstemperatur der Kühlflüssigkeit veränderlich.

Der erwünschte Druckbereich des Betriebsdruckes der Kühlflüssigkeit im Kühlkreislauf während des Regelbetriebs der Kühlanordnung kann mittels einer Steuer- und Regeleinrichtung unter Verwendung entsprechender Druck- und/oder Temperaturreglern und in Zusammenwirken mit der Vakuumpumpe geregelt sein, wobei der Betriebsdruck p1 in Abhängigkeit der jeweiligen maximalen Betriebstemperatur t1 der Kühlflüssigkeit im Kühlkreislauf, die wiederum abhängig von der zulässigen Bauteil-Temperatur ist, eingestellt wird.

Regelgröße für die Steuerung der Vakuumpumpe kann beispielsweise die Austrittstemperatur t1 der Kühlflüssigkeit aus dem /den Kühlkörpern des Belade-Wärmeübertragers sein.

So kann der Betriebsdruck der Kühlflüssigkeit beispielsweise so temperaturabhängig geregelt sein, dass er stets über dem, der jeweiligen maximalen Betriebstemperatur zugehörigem Sättigungsdampfdruck der Kühlflüssigkeit liegt.

Üblicherweise kann der Pumpendruck bzw. der Volumenstrom der Umwälzpumpe z.B. mittels einer Drehzahlregelung mit konstanter Drehzahl (leistungsunabhängig) oder mit variabler Drehzahl (leistungsabhängig) geregelt werden.

Bei einer leistungsabhängigen, temperaturabhängigen Regelung kann die Regelgröße für die Steuerung der Umwälzpumpe und damit des umlaufenden Volumenstroms der Kühlflüssigkeit beispielsweise auch die Austrittstemperatur t1 der Kühlflüssigkeit aus dem /den Kühlkörpern des Belade-Wärmeübertragers sein, um die Betriebstemperatur konstant zu halten.

Damit kann die erforderliche Energie für den Betrieb der Umwälzpumpe verringert werden.

An dem Kühlkreislauf ist ein Leitungsabzweig angeschlossen, dessen einziges Ende mit einem zweiten Vakuumbehälter verbunden ist.

Mit anderen Worten ist der Leitungsabzweig als eine vom Kühlkreislauf abgehende Stichleitung ausgebildet, an dessen Ende ein zweiter Vakuumbehälter angeordnet ist.

Der Leitungsabzweig kann beispielsweise an der Leitungsinstallation des Kühlkreislaufs, vorzugsweise der Ablauföffnung des ersten Vakuumbehälters in Strömungsrichtung der Kühlflüssigkeit nachgeordnet, ausgebildet sein, oder auch am ersten Vakuumbehälter unterhalb des Füllstands-Niveaus der Kühlflüssigkeit, vorzugsweise am Behälterboden, ausgebildet sein.

Der Leitungsabzweig kann nach einer Ausführungsform hydraulische offen ausgebildet sein, das heißt ohne jegliche Leitungs-Absperrung gegenüber dem Kühlkreislauf versehen sein und eine Steigleitung aufweisen, die in vertikaler Ausrichtung angeordnet ist und in welcher im regulären Betrieb der Kühlanordnung eine druckabhängige Flüssigkeitssäule der Kühlflüssigkeit steht.

Dagegen enthält der zweite Vakuumbehälter im Regelbetrieb der Kühlanordnung keine Flüssigkeit.

Die Steigleitung mit der Flüssigkeitssäule entspricht daher einer zwischen dem Kühlkreislauf und dem zweiten Vakuumbehälter kommunizierenden bernoullischen Röhre.

Der zweite Vakuumbehälter ist für eine dauerhafte Erhaltung des Leerzustandes im Regelbetrieb der Kühlanordnung vorzugsweise oberhalb der sich in der Steigleitung ausbildenden Flüssigkeitssäule der Kühlflüssigkeit mit dem Leitungsabzweig verbunden, wie nachstehend erörtert wird.

Der Leitungsabzweig ist mit dem zweiten Vakuumbehälter so verbunden, dass das der Steigleitung nachfolgende Ende des Leitungsabzweiges in eine Anschlussöffnung des zweiten Vakuumbehälters mündet. Der an der Anschlussöffnung angeschlossene Leitungsabzweig stellt die einzige Verbindung des zweiten Vakuumbehälters zum Kühlkreislauf der Kühlanordnung her, das heißt mit anderen Worten, dass der zweite Vakuumbehälter nur einen Zulauf und keinen Ablauf aufweist.

Die Anschlussöffnung ist im Bezug zum ersten Vakuumbehälter nach einer vorteilhaften Ausführungsform in einer geodätischen Höhe oberhalb des maximalen Füllstands-Niveaus der Kühlflüssigkeit des ersten Vakuumbehälters angeordnet. Diese Anordnung der Anschlussöffnung in Bezug zum ersten Vakuumbehälter bestimmt zugleich die Länge der vertikalen Steigleitung bis in Höhe der Anschlussöffnung.

Der ablauflose zweite Vakuumbehälter enthält im Regelbetrieb der Kühlanordnung keine Flüssigkeit und ist mit einem festeingestellten Vakuum beaufschlagt, mit anderen Worten evakuiert ausgebildet. Dazu kann beispielsweise über ein Ventil des Vakuumbehälters eine Vakuumpumpe temporär angeschlossen werden, welche das Vakuum mit einem vorbestimmten Behälterdruck einmalig in dem zweiten Vakuumbehälter erzeugt.

Der Behälterdruck des zweiten Vakuumbehälters ist im Wesentlichen zumindest gleichgroß wie der Betriebsdruck im Kühlkreislauf während des Regelbetriebs der Kühlanordnung einzustellen.

Vorzugsweise ist der Behälterdruck des zweiten Vakuumbehälters unter Berücksichtigung eines temperaturabhängig schwankenden Betriebsdruckes der Kühlflüssigkeit im Kühlkreislauf, niedriger / kleiner als der niedrigste / kleinste zu erwartende Betriebsdruck der Kühlflüssigkeit in der Kühlanordnung vorgesehen.

Mit einer derartigen Druckabsenkung (Druckdifferenz) des Behälterdrucks des zweiten Vakuumbehälters gegenüber dem Betriebsdruck der Kühlflüssigkeit im Kühlkreislauf wird die Funktionsweise des zweiten Vakuumbehälters im Leckage-Fall noch sicherer bewirkt, wie nachstehend erläutert.

Nach den Gesetzmäßigkeiten von Bernoulli kann entsprechend der Druckdifferenz in den über die Steigleitung verbundenen beiden Vakuumbehältern eine solche Flüssigkeitssäule in dieser Steigleitung ausgebildet sein, welche die Vakuumbehälter fluidtechnisch trennt.

Wenn der Behälterdruck des zweiten Vakuumbehälters im Betrieb der Kühlanordnung gleich dem Betriebsdruck der Kühlflüssigkeit im Regelbetrieb der Kühlanordnung eingestellt ist, stellt sich eine geodätische Flüssigkeitssäule in der Steigleitung, deren Füllstand im Wesentlichen dem minimalen Füllstands-Niveau (Regel-Füllstands-Niveau) im ersten Vakuumbehälter entspricht.

Falls der Behälterdruck des zweiten Vakuumbehälters im Betrieb der Kühlanordnung bevorzugt um eine bestimmte Druckdifferenz geringer gegenüber dem Betriebsdruck der Kühlflüssigkeit im Regelbetrieb der Kühlanordnung ausgebildet ist, stellt sich infolge der Druckdifferenz ein geodätisch oberhalb des Regel-Füllstands-Niveaus des ersten Vakuumbehälters ausgebildeter Füllstand der Flüssigkeitssäule der Kühlflüssigkeit in der Steigleitung ein. Mit anderen Worten ist durch die eingestellte Druckdifferenz zwischen dem Betriebsdruck der Kühlflüssigkeit im Regelbetrieb der Kühlanordnung und dem Behälterdruck des zweiten Vakuumbehälters ein der Druckdifferenz entsprechender größerer Säulenabschnitt der Flüssigkeitssäule oberhalb dem Füllstands-Niveau im ersten Vakuumbehälter ausgebildet.

Auch im Betriebsstillstand der Kühlanordnung stellt sich in beiden Fällen eine Flüssigkeitssäule der Kühlflüssigkeit in der Steigleitung ein.

Im ersten Fall ergibt sich ein Flüssigkeitsstand in der Siphonleitung, welcher dem maximalen Füllstands-Niveau im ersten Vakuumbehälter entspricht.

Im zweiten Fall ergibt sich entsprechend der beibehaltenen Druckdifferenz zwischen dem ersten und zweiten Vakuumbehälter ein Flüssigkeitsstand in der Siphonleitung oberhalb des maximalen Füllstands-Niveaus des ersten Vakuumbehälters ein.

Nach einer vorteilhaften Ausführungsform ist das Höhenmaß H der Einbindehöhe der Steigleitung in die Anschlussöffnung des zweiten Vakuumbehälter so konstruktiv gewählt, dass die Steigleitung oberhalb des maximalen Füllstands-Niveau der Kühlflüssigkeit des ersten Vakuumbehälters in den zweiten Vakuumbehälter mündet, was einerseits die Beibehaltung des Leerzustandes des zweiten Vakuumbehälters auch im Betriebsstillstand und andererseits die konstruktiv zur Verfügung stehende Länge bzw. Höhe der Steigleitung und damit eine maximal mögliche geodätische Höhe der Flüssigkeitssäule gewährleistet und folglich eine maximal zulässige Druckdifferenz zwischen dem Betriebsdruck der Kühlflüssigkeit im Regelbetrieb der Kühlanordnung und dem Behälterdruck des zweiten Vakuumbehälters, ohne ein Überströmen der Kühlflüssigkeit auszulösen.

Durch die Anbindung des zweiten Vakuumbehälters über die mit der Flüssigkeitssäule beaufschlagten Steigleitung (Siphonleitung) an den Kühlkreislauf ist also sichergestellt, dass während des Regelbetriebes der Kühlanordnung in der Art einer Überström-Barriere keine Kühlflüssigkeit in den zweiten Vakuumbehälter überströmt.

Ein Einströmen von Kühlflüssigkeit in den zweiten Vakuumbehälter wird verhindert, solange die Druckdifferenz zwischen dem Betriebsdruck der Kühlflüssigkeit der Kühlanordnung und dem Behälterdruck des zweiten Vakuumbehälters nicht die maximal mögliche geodätische Höhe der Flüssigkeitssäule überschreitet.

Alternativ kann der Leitungsabzweig anstelle der Steigleitung mit einem steuerbaren Absperrventil ausgebildet sein.

Das Absperrventil, dass beispielsweise ein Magnetventil sein kann, wird im Regelbetrieb der Kühlanordnung geschlossen gehalten.

Dieses Absperrventil, dient anstelle der Überström-Barriere durch die Flüssigkeitssäule in der Steigleitung nach der vorstehend erörterten Ausführung der Kühlanordnung einer alternativen strömungstechnischen und drucktechnischen Trennung des zweiten Vakuumbehälters vom Kühlkreislauf während des Regelbetriebs der Kühlanordnung.

Das heißt, dass in dem Fall eine Steigleitung mit Flüssigkeitssäule entbehrlich ist.

Durch die Absperrung des Leitungsabzweiges kann der Behälterdruck im zweiten Vakuumbehälter unabhängig vom Betriebsdruck im Kühlkreislauf und unabhängig von einer konstruktiv auszubildenden Steigleitung mit Flüssigkeitssäule eingestellt werden, insbesondere kann im Regelbetrieb der Kühlanordnung eine größere Druckdifferenz des Behälterdrucks im zweiten Vakuumbehälter gegenüber dem Betriebsdruck des Kühlkreislaufes erzeugt werden und damit der Behälterdruck im zweiten Vakuumbehälter noch deutlicher, bis zu einem absoluten Druck nahe 0 bar, abgesenkt und gehalten werden.

Unterhalb der für die Einmündung des Leitungsabzweiges vorgesehenen Anschlussöffnung ist der zweite Vakuumbehälter mit einem Behälterraum (Fluidspeicherraum) ausgebildet, welcher ein Fluidspeichervolumen bereithält, der zumindest einer kritischen Teilmenge der im Kühlkreislauf enthaltenen Kühlflüssigkeit entspricht.

Als kritische Teilmenge an Kühlflüssigkeit kann beispielsweise diejenige Teilmenge anzusehen sein, welche sich bei einem Betriebsstillstand der Kühlanordnung in dem der CPU angrenzenden Belade-Wärmeübertrager einschließlich dessen Rohleitungen sammelt und verbleibt und demnach in einem Havariefall mit einem nahe der CPU gelegenen Leck analog verbleiben und auslaufen würde.

Die geodätische Höhenlage der CPU und damit des Belade-Wärmeübertragers im Bezug zum maximalen Füllstands-Niveau des ersten Vakuumbehälters beeinflusst die zu berücksichtigende kritische Teilmenge an Kühlflüssigkeit für die Auslegung der Mindestgröße des Fluidspeicherraums des zweiten Vakuumbehälters.

Das maximal mögliche Fluidspeichervolumen des zweiten Vakuumbehälters ist stets auf den sich unterhalb der Anschlussöffnung ausgebildeten Behälterraum (Fluidspeicherraum) begrenzt. Mit anderen Worten begrenzt die Lage der Anschlussöffnung am zweiten Vakuumbehälters das maximal mögliche Füllstands-Niveau des zweiten Vakuumbehälters und damit das mögliche Fluidspeichervolumen. Vorzugsweise ist die Anschlussöffnung nahe dem oberen Deckel des zweiten Vakuumbehälters angeordnet.

Der zweite Vakuumbehälter ist damit derart ausgebildet, dass dieser in einem Leckage-Fall zumindest eine kritische Teilmenge der im Kühlkreislauf enthaltenen Kühlflüssigkeit, vorzugsweise das gesamte Volumen an Kühlflüssigkeit im Kühlkreislauf aufnehmen kann.

Der zweite Vakuumbehälter und die Steigleitung sind derart ausgebildet und in Bezug zum ersten Vakuumbehälter angeordnet, und weiter der zweite Vakuumbehälter drucktechnisch derart in Bezug zum Betriebsdruck des Kühlkreislaufs eingestellt, dass im regulären Betrieb der Kühlanordnung der zweite Vakuumbehälter leer bleibt und dieser sich nur bei einer Leckage füllen kann.

Bei einer Leckage, die durch eine Undichtheit in der Kühlanordnung und der damit verbundenen Verbindung zum deutlich höheren Umgebungsdruck entstehen kann, steigt der Druck im Kühlkreislauf rasch an, so dass sich die Druckdifferenz zwischen dem Betriebsdruck der Kühlflüssigkeit und dem Behälterdruck des zweiten Vakuumbehälters vergrößert und der zulässige Druck entsprechend der Flüssigkeitssäule in der Steigleitung überschritten wird, das heißt, dass die geodätische Höhe der Flüssigkeitssäule in der Steigleitung überwunden wird, wobei die Kühlflüssigkeit über die Steigleitung zwangsläufig und selbstregelnd aus dem Kühlkreislauf in den zweiten Vakuumbehälter überströmt.

Je höher die geodätische Höhe der Flüssigkeitssäule oberhalb des Füllstands-Niveaus des ersten Vakuumbehälters ausgebildet werden kann, umso größer kann die Druckdifferenz im zweiten Vakuumbehälter vorgehalten werden. Folglich kann im Leckage-Fall umso stärker und schneller die Kühlflüssigkeit vollständig in den zweiten Vakuumbehälter gesaugt werden.

In der Ausführung des Leitungsabzweiges mit Absperrventil wird bei einer Leckage, bei der die zulässige Druckdifferenz zwischen dem Betriebsdruck der Kühlflüssigkeit und dem Behälterdruck des zweiten Vakuumbehälters überschritten wird, dass Absperrventil durch eine geeignete Ansteuerung geöffnet, wobei die Kühlflüssigkeit druckabhängig aus dem Kühlkreislauf in den zweiten Vakuumbehälter überströmt.

Die erfindungsgemäße Ausführung erlaubt es also, dass erst wenn es zu einem größeren Leck in der Kühlanordnung mit einem erheblichen Druckanstieg kommt, welcher durch die Vakuumdruckhaltung im Kühlkreislauf bzw. durch die erste Vakuumpumpe nicht mehr kompensiert werden kann, so dass die zulässige Druckdifferenz zwischen ersten Vakuumbehälter und zweiten Vakuumbehälter überschritten wird, die Kühlflüssigkeit in den zweiten Vakuumbehälter strömt.

Auch nach Einstellen eines Druckausgleichs zwischen Kühlkreislauf und Umgebung kann keine Kühlflüssigkeit aus der Kühlanordnung austreten, da sich die kritische Teilmenge oder vorzugsweise die vollständige Menge an Kühlflüssigkeit in dem ablauflosen zweiten Vakuumbehälter gesammelt hat und nicht über dessen Anschlussöffnung zurückströmen kann.

Mit der erfindungsgemäßen Kühlanordnung wird gewährleistet, dass bei jeglichem Leck, insbesondere auch bei größeren Leckagen (Havariefall) in der Kühlanordnung keine Kühlflüssigkeit auslaufen kann.

Dies erfolgt einerseits durch Druckhaltung eines absoluten Drucks im Kühlkreislauf unter dem Umgebungsdruck (subatmosphärischer Betriebsdruck, Unterdruck) und andererseits durch das druckabhängige, selbsttätige oder gesteuerte Überströmen der kritischen Teilmenge der Kühlflüssigkeit, vorzugsweise der gesamten Menge an Kühlflüssigkeit im Kühlkreislauf in den zweiten, auslaufsicheren Vakuumbehälter (Havarie-Modus), bevor sich ein Druckausgleich des Kühlkreislaufes mit der Umgebung einstellt.

Damit gewährleistet die Kühlanordnung eine hohe Betriebssicherheit zum Schutz der Baugruppen und Komponenten des Computersystems.

Zur Lösung der gestellten Aufgabe ist erfindungsgemäß eine alternative Kühlanordnung nach Anspruch 2 für ein Zweiphasen-Kühlsystem vorgesehen, wobei die alternative Kühlanordnung in ihrem Kühlkreislauf ein Kühlmittel als Kühlmedium enthält und den Phasenwechsel des Kühlmittels von fluider in gasförmige Phase und umgekehrt nutzt, so dass das Kühlmittel im Kühlkreislauf der Kühlanordnung sowohl in fluider als auch in gasförmiger Form vorliegt.

Hiermit sind ebensolche vorteilhaften Ausführungsformen und Kombinationsmöglichkeiten mit denselben Vorteilen, wie vorstehend bei der Kühlanordnung nach Anspruch 1 beschrieben, realisierbar und darüber hinaus noch weitere Vorteile erzielbar.

Sämtliche vorbeschriebenen erfindungsgemäßen Merkmale, Funktionen, Effekte und vorteilhaften Ausgestaltungen der Kühlanordnung nach Anspruch 1 als Einphasen-Kühlsystem gelten auch für die alternative Kühlanordnung mittels Kühlmittel als Zweiphasen-Kühlsystem nach Anspruch 2, so dass zur Vermeidung von Wiederholungen vollumfänglich auf die vorstehenden Ausführungen verwiesen wird.

Nachfolgend werden zur Vermeidung von Wiederholungen nur die Unterschiede und weiteren Vorteile gegenüber der Ausführung der Kühlanordnung als Einphasen-Kühlsystem gemäß Anspruch 1 beschrieben.

Im Unterschied zur Kühlanordnung nach Anspruch 1 wird das Kühlmedium (hier ein Kühlmittel) anstelle dem Belade-Wärmeübertrager in wenigstens einem Verdampfer teilweise oder vollständig verdampft und anschließend in einem Kondensator wieder kondensiert.

Das als Kühlmedium verwendete Kühlmittel kann eines der als Kühlmittel gängigen Stoffe, wie z.B. Wasser oder NOVEC 7200 sein, welches bei Kühltemperatur im Unterdruck die Fähigkeit des Phasenwechsels zwischen einer flüssigen und gasförmigen Phase aufweist.

Mittels der Umwälzpumpe im Kühlkreislauf wird das fluide Kühlmittel durch einen oder mehrere Verdampfer gefördert, in welchem Betriebswärme aus einem oder mehreren elektrisch und/oder elektronisch betriebenen Komponenten des zu kühlenden Computersystems (z.B. CPUs /GPUs) an das thermisch kältere Kühlmittel abgegeben wird, während dessen das Kühlmittel zumindest teilweise verdampft, also in den dampf- bzw. gasförmigen Zustand wechselt.

Der oder die Verdampfer kann /können für die Übertragung der Betriebswärme z.B. einen oder mehrere Kühlkörper aufweisen, die jeweils an einer CPU oder GPU angeordnet sind, wobei auch die Verdampfer-Kühlkörper - analog der Kühlkörper eines Belade-Wärmetauschers - innerhalb eines Verdampfers in Reihe und/oder parallel geschaltet sein können.

Mit anderen Worten verdampft das Kühlmittel teilweise oder vollständig in dem /den Verdampfer(n) durch die Aufnahme der von den elektrisch und/oder elektronisch betriebenen Komponenten des zu kühlenden Computersystems abgegebenen Wärme.

Die Verdampfung bzw. Teilverdampfung erfolgt mit Erreichen der dem Sättigungsdampfdruck des Kühlmittels zugehörigen Verdampfungstemperatur.

Mit anderen Worten ist in der Kühlanordnung nach Anspruch 2 (Zweiphasen-Kühlsystem) ein niedrigerer Betriebsdruck als in der Kühlanordnung nach Anspruch 1 (Einphasen-Kühlsystem), nämlich ein Betrieb bei einem der Betriebstemperatur des Kühlmittels zugehörigen Sättigungsdampfdruck des Kühlmittels, vorgesehen.

Da die zulässigen Bauteil-Temperaturen der zu kühlenden Baugruppen bzw. Komponenten eines Computersystems üblicherweise bei maximal 80 °C liegen, kann beispielsweise bei der Verwendung von Wasser als Kühlmittel bei einem Betriebsdruck im Kühlkreislauf nahe dem oder beim Sättigungsdampfdruck des Kühlmittels, mit einer Verdampfungstemperatur des Kühlmittels nahe der zulässigen Bauteil-Temperatur operiert werden. Zum Beispiel liegt der Sättigungsdampfdruck von Wasser bei einer Temperatur von 75 °C bei 386 mbar.

Nach der Wärmeaufnahme kann das Kühlmittel vollständig (in flüssiger und/oder dampfförmiger Phase) durch den Kondensator strömen, in welchen die dampfförmige Phase des Kühlmittels vollständig kondensiert, d.h. in den flüssigen Zustand wechselt und ggf. auch die flüssige Phase abgekühlt wird.

Im Kondensator wird zumindest ein Teil der vom Kühlmittel zuvor aus dem Computersystem aufgenommenen Wärme an ein externes fluides oder gasförmiges Wärmeübertragungsmedium, wie zum Beispiel Wasser oder Luft, abgegeben, der damit zumindest anteilig eine Entlade-Funktion eines Entlade-Wärmeübertragers übernimmt.

Alternativ kann eine Bypass-Leitung zur Umgehung des Kondensators vorgesehen sein, in der vor der Zuführung zum Kondensator eine Trennung der flüssigen Phase des Kühlmittels von der dampfförmigen Phase erfolgt, so dass nur die dampfförmige Phase zur Kondensation durch den Kondensator strömt.

Die flüssige Phase behindert somit nicht die Kondensation im Kondensator und erhöht damit dessen Effizienz. Zudem ergeben sich geringere Druckverluste saugseitig des Kondensators.

Im Zusammenschluss der Leitungszweige nach dem Kondensator werden das Kühlmittel in vollständig flüssiger Phase zusammengeführt.

Der sich im Kühlreislauf dem Kondensator anschließende erste Vakuumbehälter wird mit dem gesamten Kühlmittel in vollständig fluider Phase durchströmt. Dieser Vakuumbehälter ist - analog der Kühlanordnung nach Anspruch 1 - im Regelbetrieb der Kühlanordnung bis zu einem bestimmten Füllstands-Niveau (Betriebs-Füllstands-Niveau) und im Betriebsstillstand bis zum maximalen Füllstands-Niveau (Ruhe-Füllstands-Niveau) mit dem fluiden Kühlmittel gefüllt.

Anschließend wird das Kühlmittel in vollständig fluider Phase durch den Entlade-Wärmeübertrager gefördert, wobei der restliche Teil der vom Kühlmittel aus dem Computersystem aufgenommenen Wärme an ein externes fluides oder gasförmiges Wärmeübertragungsmedium, wie zum Beispiel Wasser oder Luft, übertragen wird und dabei das fluide Kühlmittel abgekühlt wird, bevor es wieder dem /den Verdampfer(n) zugeführt wird.

Das Fluidspeichervolumen des zweiten Vakuumbehälters ist analog der Ausführung nach Anspruch 1 zur Aufnahme zumindest einer kritischen Teilmenge, vorzugsweise des gesamten Volumens des Kühlmittels im Kühlkreislauf ausgebildet.

Die Kühlanordnung nach Anspruch 2 bewirkt ebenso alle vorbeschriebenen Vorteile der Erfindung gemäß Anspruch 1.

Zudem kann bei der Kühlanordnung nach Anspruch 2 mithilfe des ausgebildeten Zweiphasen-Kühlsystems, insbesondere durch die Verdampfung bzw. Teilverdampfung des Kühlmittels in dem /den Verdampfer-Kühlkörper(n) eine höhere Energiemenge bzw. Wärmemenge bei gleichem Massenstrom des umlaufenden Kühlmittels im Vergleich zum umlaufenden Kühlmedium des Einphasen-Kühlsystems im Kühlkreislauf aufgenommen und abgeführt werden.

Weiterhin werden durch die Verdampfung bzw. Teilverdampfung des Kühlmittels in dem(n) Verdampfer(n) größere Wärmeübergangskoeffizienten erreicht, die entweder zu einer geringeren Bauteil-Temperatur der zu kühlenden Baugruppen bzw. Komponenten eines Computersystems bei gleicher Kühlmitteltemperatur oder zu einer höheren Kühlmitteltemperatur bei gleichbleibender Bauteil-Temperatur führen. Die nutzbare Betriebstemperatur kann nahe der zulässigen Bauteiltemperatur, bis zu 80°C, betragen.

Hierdurch kann eine höhere Leistungsdichte bei den Baugruppen bzw. Komponenten eines Computersystems zugelassen sein und die Temperaturverteilung in den elektronischen Baugruppen bzw. Komponenten kann vergleichmäßigt werden.

Somit kann im Weiteren bei gleichgroß abzuführender Wärmeenergie bzw. Wärmemenge die Menge an umlaufendem Kühlmittel im Kühlkreislauf der Kühlanordnung deutlich reduziert werden und folglich u. a. zumindest das für den Leckage-Fall vorzuhaltende Fluidspeichervolumen des zweiten Vakuumbehälters verringert werden, womit der zweite Vakuumbehälter platzsparend kleiner ausgebildet sein kann.

Nach einer weiteren vorteilhaften Ausgestaltung der Erfindung nach Anspruch 1 oder 2 weist der zweite Vakuumbehälter einen Fluidspeicherraum auf, dessen Fluidspeichervolumen mindestens dem Gesamtvolumen des im Kühlkreislauf enthaltenen Kühlmediums entspricht.

Mit anderen Worten ist das Fluidspeichervolumen des zweiten Vakuumbehälters nach dieser vorteilhaften Ausgestaltung mindestens so groß bemessen, wie das Gesamtvolumen der im Kühlkreislauf enthaltenen Kühlflüssigkeit bzw. des im Kühlkreislauf enthaltenen Kühlmittels. Der zweite Vakuumbehälter ist damit derart ausgebildet, dass dieser in einem Leckage-Fall das gesamte Volumen an Kühlflüssigkeit bzw. an Kühlmittel vollständig aufnehmen kann, unabhängig von der Anordnung / Lage der CPU gegenüber dem maximalen Füllstands-Niveau im ersten Vakuumbehälter.

Nach einer weiteren vorteilhaften Ausgestaltung der Erfindung weist der zweite Vakuumbehälter einen oberhalb der Anschlussöffnung ausgebildeten Behälterraum (Gasspeicherraum) mit einem entsprechenden Gasspeichervolumen auf. Der oberhalb der Anschlussöffnung des zweiten Vakuumbehälters ausgebildete Behälterraum (Gasspeicherraum) bestimmt das mindestens mögliche Gasspeichervolumen des zweiten Vakuumbehälters.

Hierdurch kann bei der Leckage zusätzlich zu dem gesamten fluiden Volumen des Kühlmediums (Kühlflüssigkeit bzw. Kühlmittel), ein eventuell durch das Leck aus der Umgebung angesaugtes und in den Kühlkreislauf einströmendes Luftvolumen (Leckage-Luftvolumen), welches beim Rücksaugen des Kühlmediums in den zweiten Vakuumbehälter mitgeführt wird, in diesen gesonderten Behälterraum aufgenommen werden.

Mit anderen Worten steht der unterhalb der Anschlussöffnung des zweiten Vakuumbehälters ausgebildete Behälterraum (Fluidspeicherraum)des zweiten Vakuumbehälters gänzlich für die Speicherung des fluiden Volumens des Kühlmediums (Kühlflüssigkeit bzw. Kühlmittel) zur Verfügung, während der oberhalb der Anschlussöffnung des zweiten Vakuumbehälters ausgebildete Behälterraum (Gasspeicherraum) des zweiten Vakuumbehälters für die Speicherung des mitgeführten Leckage-Luftvolumens vorgehalten wird. Damit kann sichergestellt werden, dass trotz Mitführung von Leckage-Luftvolumen das gesamte fluide Kühlmedium des Kühlkreislaufes (Kühlflüssigkeit bzw. Kühlmittel) im zweiten Speicherbehälter aufgenommen werden kann.

Nach einer weiteren vorteilhaften Ausgestaltung der Erfindung ist eine Steuer- und Regeleinrichtung vorgesehen, welche den Betriebsdruck des Kühlmediums (Kühlflüssigkeit bzw. Kühlmittel) temperaturabhängig zwischen einem unteren und oberen Druckgrenzwert regelt.

Der untere Druckgrenzwert entspricht einem mittels der Steuer- und Regeleinrichtung ermittelten und voreingestellten unteren Sollwert des absoluten Drucks p1 im Kühlkreislauf, welcher dem minimal erwünschten Betriebsdruck im Regelbetrieb der Kühlanordnung entspricht.

In der Kühlanordnung nach Anspruch 1 muss der minimale Betriebsdruck stets größer als der Sättigungsdampfdruck des Kühlmediums (Kühlflüssigkeit) entsprechend der jeweils zugehörigen Betriebstemperatur t1 der Kühlflüssigkeit sein.

In der Kühlanordnung nach Anspruch 2 ergibt sich der untere Druckgrenzwert in Abhängigkeit des der Betriebstemperatur t1 zugehörigen Verdampfungsdrucks bzw. Kondensationsdrucks des Kühlmediums (Kühlmittels), also in Abhängigkeit des Sättigungsdampfdrucks des Kühlmediums (Kühlmittels) ....

Der oberer Druckgrenzwert entspricht einem mittels der Steuer- und Regeleinrichtung ermittelten und voreingestellten oberen zulässigen Sollwert des absoluten Drucks p1 im Kühlkreislauf, welcher kleiner als der atmosphärische Umgebungsdruck ist und einen unerwünschten Anstieg des Betriebsdruckes im Kühlkreislauf infolge einer Leckage signalisieren soll.

Beim Erreichen des oberen Druckgrenzwertes erfolgt mittels der Steuer- und Regeleinrichtung eine Ansteuerung/Zuschaltung der Vakuumpumpe des ersten Vakuumbehälters und beim Erreichen des unteren Druckgrenzwertes erfolgt die Abschaltung dieser Vakuumpumpe.

Diese Vakuumpumpe kann im Einschaltbetrieb leistungsunabhängig, das heißt mit maximaler Pumpenleistung, betrieben sein.

Tritt im Betrieb der Kühlanordnung ein Leck auf, so strömt als Erstes Luft in den Kühlkreislauf ein und erhöht somit den absoluten Druck p1 im Kühlkreislauf und ebenso im ersten Vakuumbehälter.

Die Steuer- und Regeleinrichtung, die den absoluten Druck p1(Betriebsdruck)im Kühlkreislauf überwacht, erkennt ein Erreichen des oberen Druckgrenzwertes und schaltet die erste Vakuumpumpe ein, welche den absoluten Druck im Kühlkreislauf senkt, bis dieser zumindest den Wert des unteren Druckgrenzwertes erreicht hat, wo die Steuer- und Regeleinrichtung die erste Vakuumpumpe wieder abschalten kann.

Bei andauerndem Lufteintritt geringen Ausmaßes kann zur Vermeidung eines Flüssigkeitsaustrittes zunächst die erste Vakuumpumpe dauerhaft betrieben sein.

Kleinere und mittlere Lecks können daher generell durch die Ansteuerung der ersten Vakuumpumpe kompensiert werden.

Somit kann bereits bei kleinen und weniger erheblichen Undichtigkeiten in der Kühlanordnung mittels der sensibel wirkenden Steuer- und Regeleinrichtung ein schneller und sicherer Schutz des Computersystems gewährleistet werden, ohne dass die Kühlanordnung verfrüht in den Havarie-Modus wechseln muss.

Erst wenn der absolute Druck trotz laufender erster Vakuumpumpe den vorgegebenen oberen Druckgrenzwertes überschreitet, das heißt beim Auftreten eines größeren Lecks, erfolgt im Weiteren durch das vorbeschriebene druckabhängige Zusammenwirken des zweiten Vakuumbehälters mit dem Kühlkreislauf das selbstregelnde Rücksaugen einer kritischen Teilmenge des Kühlmediums, vorzugsweise des gesamten Kühlmediums in den zweiten Vakuumbehälter, womit der Havariefall durch die größere Leckage automatisch und sicher verhindert wird.

Nach einer weiteren vorteilhaften Ausführungsform der Erfindung ist an dem zweiten Vakuumbehälter eine zweite Vakuumpumpe angeschlossen.

Die zweite Vakuumpumpe kann zur Evakuierung des zweiten Vakuumbehälters genutzt werden und zur Druckhaltung im zweiten Vakuumbehälter bei einem bestimmten, besonders niedrigeren Behälterdruck gegenüber dem Betriebsdruck im ersten Vakuumbehälter dienen.

Vorzugsweise ist nach einer weiteren vorteilhaften Ausführungsform die Steuer- und Regeleinrichtung derart ausgebildet, dass bei Überschreiten des oberen Druckgrenzwertes des Betriebsdruckes des Kühlmediums die zweite Vakuumpumpe zugeschaltet wird.

Die Steuer- und Regeleinrichtung realisiert unter dem Vorrang des Regelbetriebs der ersten Vakuumpumpe in einem Regelbereich zwischen einem unteren und oberen Druckgrenzwert des Betriebsdruckes, eine zusätzliche Regelungsfunktion im Havarie-Modus, nämlich indem bei einem Überschreiten des oberen Druckgrenzwertes des Betriebsdrucks die zweite Vakuumpumpe zugeschaltet wird.

Mit anderen Worten wird die zweite Vakuumpumpe vorrangig im Havarie-Fall, bei Überschreiten des oberen Druckgrenzwertes, betrieben. Solange der oberen Druckgrenzwert nicht überschritten wird, kann die zweite Vakuumpumpe temporär zur Differenzdruckhaltung des Vakuums im zweiten Vakuumbehälter bereitgehalten sein.

Die zweite Vakuumpumpe kann eine Pumpenleistung aufweisen, die gleichgroß, vorzugsweise größer ist, als die Pumpenleistung erste Vakuumpumpe.

Im Parallelbetrieb beider Vakuumpumpen bei Überschreiten des oberen Druckgrenzwertes erfolgt eine Summierung der jeweiligen Saugleistungen (Volumenströme) der Vakuumpumpen.

Sobald der absolute Druck trotz laufender erster Vakuumpumpe den vorgegebenen oberen Druckgrenzwert überschreitet, wird die zweite Vakuumpumpe eingeschaltet, die dann den Behälterdruck im zweiten Vakuumbehälter weiter absenkt.

Dadurch wird das Kühlmedium über die Steigleitung schneller in den zweiten Vakuumbehälter gesaugt, aus dem die Kühlflüssigkeit nicht zurückfließen kann. Im Zusammenwirken beider Vakuumpumpen der Kühlanordnung kann daher die zur Vermeidung von Flüssigkeitsaustritt erforderliche Druckabsenkung und Rücksaugung in den zweiten Vakuumbehälter besonders schnell realisiert werden.

Mittels der zweiten Vakuumpumpe kann insbesondere die bei Leckagen eingedrungene und mitgeführte Luft aus der Kühlanordnung schneller abgesaugt werden, so dass auch bei einem größeren Leckage-Fall (Havarie-Fall) mit erheblich nachströmender Luft der absolute Unterdruck in der Kühlanordnung länger gehalten werden kann und das Kühlmedium schnell und vollständig in den zweiten Vakuumbehälter befördert werden kann.

Durch den Betrieb der zweiten Vakuumpumpe wird somit der Zeitraum bis zu einem Druckausgleich zwischen Kühlkreislauf und der Umgebung verlängert, so dass mehr Zeit zur Verfügung steht, um das Kühlmedium in den zweiten Vakuumbehälter zu sammeln.

Zudem kann beim Einsatz der zweiten Vakuumpumpe das vorzuhaltende Gasspeichervolumen des zweiten Vakuumbehälters für die zu sammelnde Luft platzsparend kleiner ausfallen.

Ist die Pumpenleistung der zweiten Vakuumpumpe vorzugsweise größer als die Pumpenleistung der ersten Vakuumpumpe, kann der vorbeschriebene Havarie-Modus der Kühlanordnung deutlich beschleunigt werden.

Mit höherer Saugleistung der zweiten Vakuumpumpe kann zudem die notwendige Differenzdruck-Vorhaltung des zweiten Vakuumbehälters im Regelbetrieb der Kühlanordnung, minimiert werden, da bei größerer Leckage (im Havarie-Fall) mithilfe der größerer Pumpenleistung der zweiten Vakuumpumpe unmittelbar eine ausreichend hohe Druckdifferenz zum Kühlkreislauf erzeugt werden kann, um das Kühlmedium noch schneller in den zweiten Vakuumbehälter zu saugen.

Die zweite Vakuumpumpe kann mittels der Steuer- und Regeleinrichtung zudem vorzugsweise derart regelbar ausgebildet sein, dass die Differenzdruckhaltung des Behälterdrucks im zweiten Vakuumbehälter in Abhängigkeit der temperaturabhängigen Betriebsdruckschwankungen im Regelbetrieb der Kühlanordnung veränderlich geführt wird, so dass der Differenzdruck in stabiler Grö-ße gehalten werden kann und somit die Rücksaugfunktion der Kühlanordnung im Havarie-Modus präziser und damit zuverlässiger wirksam sein kann.

Vorzugsweise ist nach einer weiteren vorteilhaften Ausführungsform die Steuer- und Regeleinrichtung derart zur Steuerung des Absperrventils ausgebildet, dass das während des Regelbetriebs der Kühlanordnung geschlossen gehaltene Absperrventil bei Überschreiten des oberen Druckgrenzwertes des Betriebsdruckes des Kühlmediums geöffnet wird.

Das Absperrventil, ist mithilfe der Steuer- und Regeleinrichtung so gesteuert, dass es im Regelbetrieb der Kühlanordnung, das heißt bei einem geringeren Betriebsdruck als dem oberen Druckgrenzwert, geschlossen bleibt, so dass der Leitungsabzweig gegenüber dem Kühlkreislauf hydraulisch getrennt ist.

Ist das Absperrventil mithilfe der Steuer- und Regeleinrichtung geöffnet, ist die druck- und strömungstechnische Kommunikation des zweiten Vakuumbehälters mit dem Kühlkreislauf freigegeben.

Tritt eine Havarie / Leckage auf und der Betriebsdruck im Kühlkreislauf steigt über einen vorgegebenen oberen Druckgrenzwert an, öffnet sich das Absperrventil und das vorzugsweise gesamte Kühlmedium kann selbsttätig und vollständig in den zweiten Vakuumbehälter strömen. Durch den besonders niedrigen absoluten Druck und damit hohen Unterdruck gegenüber der Umgebung im zweiten Vakuumbehälter kann das Kühlmedium infolge des erzeugten hohen Differenzdruckes mit großem Rücksaugvolumenstrom noch schneller in den zweiten Vakuumbehälter strömen.

Die Steuer- und Regeleinrichtung kann des Weiteren so ausgebildet sein, dass bei Erreichen eines Vollfüllstands-Niveau im zweiten Vakuumbehälter, der dem gesamten Flüssigkeitsvolumen des Kühlmediums in der Kühlanordnung entspricht, und / oder bei Erreichen eines Druckausgleichs zwischen dem Kühlkreislauf und der Umgebung das Absperrventil unmittelbar wieder geschlossen wird.

Diese erfindungsgemäße Ausgestaltung der Kühlanordnung ermöglicht die Anordnung des zweiten Vakuumbehälters unabhängig von der Ausführung einer Steigleitung und unabhängig von der Lage der Anschlussöffnung des zweiten Vakuumbehälters in Bezug zum maximalen Füllstands-Niveau des ersten Vakuumbehälters frei zu wählen, da hierbei ein Rückströmen der Kühlflüssigkeit in den Kühlkreislauf mithilfe des steuerungstechnisch schließbaren Absperrventils verhindert wird.

Zudem ergibt sich durch den sehr niedrigen absoluten Druck - und dementsprechend sehr geringen Luft- bzw. Gasvolumen - im zweiten Vakuumbehälter entsprechend mehr Speicherkapazität für die Speicherung der Leckage-Luft aus dem Kühlkreislauf, so dass das vorzuhaltende Gasspeichervolumen des zweiten Vakuumbehälters weiter verringert werden kann.

Diese und weitere aus den Patentansprüchen, der Beschreibung der Ausführungsbeispiele und den Zeichnungen hervorgehenden Merkmale können jeweils für sich oder in Kombination als vorteilhafte Ausführungsformen der Erfindung verwirklicht sein, für die hier Schutz beansprucht wird.

Die erfindungsgemäßen Anordnungen werden nachfolgend an verschiedenen Ausführungsbeispiel näher erläutert. Die zugehörigen Zeichnungen zeigen in einer schematischen Darstellung in
- Fig. 1: ein Schaltbild der erfindungsgemäßen Kühlanordnung mit einem Kühlkreislauf, welcher Wasser als Kühlmedium enthält, und mit einem zweiten Vakuumbehälter, welcher über eine Siphonleitung mit dem Kühlkreislauf verbunden ist,
- Fig. 2: ein Schaltbild der erfindungsgemäßen Kühlanordnung nach Fig. 1 mit einer am zweiten Vakuumbehälter angeschlossenen zweiten Vakuumpumpe,
- Fig. 3: ein Schaltbild der erfindungsgemäßen Kühlanordnung nach Fig. 1 mit einer absperrbaren Siphonleitung,
- Fig. 4: ein Schaltbild einer erfindungsgemäßen Kühlanordnung mit einem alternativen Kühlkreislauf, welcher Wasser als Kühlmittel in fluider und gasförmiger Phase enthält, und mit einem zweiten Vakuumbehälter, welcher über eine Siphonleitung mit dem Kühlkreislauf verbunden ist.

In den im Folgenden erläuterten Ausführungsbeispielen wird auf die beigefügten Zeichnungen Bezug genommen, die einen Teil der Beispiele bilden und in denen zur Veranschaulichung spezifische Ausführungsformen gezeigt sind, in denen die Erfindung ausgeübt werden kann.

In dieser Hinsicht wird Richtungsterminologie wie etwa "oben", "unten", "vorne", "hinten", "vorderes", "hinteres" usw. mit Bezug auf die Orientierung der beschriebenen Figuren verwendet. Da Komponenten von Ausführungsformen in einer Anzahl verschiedener Orientierungen positioniert werden können, dient die Richtungsterminologie zur Veranschaulichung und ist auf keinerlei Weise einschränkend.

Es versteht sich, dass andere Ausführungsformen der Erfindung und strukturelle oder logische Änderungen der Erfindung von dem Schutzumfang der vorliegenden Erfindung umfasst sind.

Es versteht sich zudem, dass die Merkmale der hierin beschriebenen verschiedenen beispielhaften Ausführungsformen miteinander kombiniert werden können, sofern nicht spezifisch anders angegeben.

Die folgende ausführliche Beschreibung der Ausführungsbeispiele ist deshalb nicht in einschränkendem Sinne aufzufassen.

In den Figuren werden identische oder ähnliche Elemente mit identischen Bezugszeichen versehen, soweit dies zweckmäßig ist.

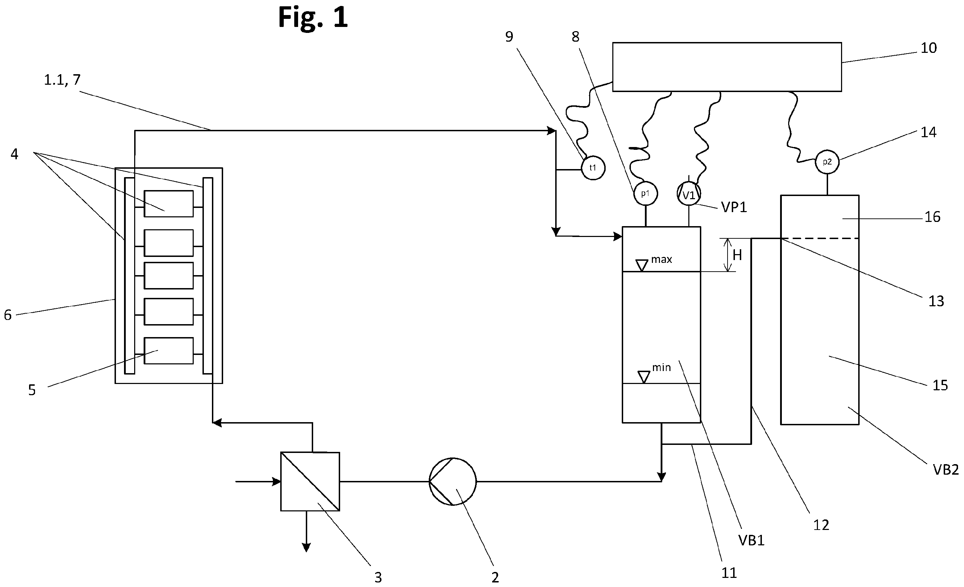

Die Kühlanordnung nach Fig. 1 weist einen Kühlkreislauf 1.1 auf, umfassend die Funktionselemente Umwälzpumpe 2, Entlade-Wärmeübertrager 3, Belade-Wärmeübertrager 4 mit den Kühlkörpern 5 und einen ersten Vakuumbehälter VB1 sowie Rohrleitungen einer Leitungsinstallation 7, welche die genannten Funktionselemente 2, 3, 4, 5 und VB1 miteinander verbinden.

Der Kühlkreislauf 1.1 enthält Wasser als Kühlmedium bzw. Kühlflüssigkeit, welches mithilfe der Umwälzpumpe 2 in angegebener Pfeilrichtung (Strömungsrichtung) umlaufend durch den Kühlkreislauf 1.1 fördert wird.

Der Belade-Wärmeübertrager 4 ist in einem Server 6 angeordnet, welcher mehrere zu kühlende CPUs enthält.

Der Belade-Wärmeübertrager 4 weist in diesem Ausführungsbeispiel mehrere Kühlkörper 5 auf, die jeweils an einer CPU des Servers 6 angefügt sind und die durch interne Rohleitungen zwischen einem Verteil-Kanal und einem Sammel-Kanal des Belade-Wärmeübertragers 4 in einer Parallel-Schaltung angeordnet sind und in der Weise parallel vom Wasser des Kühlkreislaufes 1.1 durchströmt werden.

Beim Durchströmen der Kühlkörper 5 wird Betriebswärme aus den anliegenden elektrisch und/oder elektronisch betriebenen Komponenten der CPUs an das kältere Wasser abgegeben, wobei es sich erwärmt, also mit Wärmeenergie "beladen" wird.

Das erwärmte Wasser strömt über eine Zulauföffnung in einen ersten Vakuumbehälter VB1, welcher mit einem anteiligen Volumen an Wasser gefüllt ist und oberhalb eines Füllstands-Niveaus ein Gasvolumen / Gaspolster aufweist.

Im Regelbetrieb der Kühlanordnung stellt sich ein minimales Füllstands-Niveau (Regel-Füllstands-Niveau) im ersten Vakuumbehälter VB1 ein (wie mit ▼ ^{min} dargestellt) .

Im Betriebsstillstand der Kühlanordnung, bei Betriebsstillstand der Umwälzpumpe 2 stellt sich ein maximales Füllstands-Niveau (Ruhe-Füllstands-Niveau) im ersten Vakuumbehälter VB1 ein (wie mit ▼ ^{max} dargestellt).

An der Oberseite des ersten Vakuumbehälters VB1 ist eine Vakuumpumpe VP1 angeschlossen, mittels der im Kühlkreislauf 1.1 der gewünschte Betriebs(Unter-)druck, d. h. ein absoluter, subatmosphärischer Druck p1, welcher kleiner als der atmosphärische Druck der Umgebungsluft ist, erzeugt und gehalten wird (Druckhaltung).

Über eine Ablauföffnung des ersten Vakuumbehälters VB1 wird das Wasser von der Umwälzpumpe 2 aus dem ersten Vakuumbehälter angesaugt und dem Entlade-Wärmeübertrager 3 zugeführt.

Im Entlade-Wärmeübertrager 3 wird die vom Wasser aufgenommene Wärme aus den CPUs des Servers 6, z.B. mittels eines Gegenstrom-Platten-Wärmeübertragers, an ein externes Wärmeübertragungsmedium, hier z.B. Wasser, übertragen, wobei sich das Wasser (die Kühlflüssigkeit im Kühlkreislauf 1.1) abkühlt, also von der Wärmeenergie "entladen" wird.

Das Wasser wird weiter zum Belade-Wärmeübertrager 4 gefördert um permanent Betriebswärme aus den CPUs aufzunehmen.

Die Kühlanordnung weist des Weiteren einen Drucksensor 8 für die Erfassung des Meßwertes des Betriebsdrucks (absoluter Druck) p1 im Kühlkreislauf 1.1, insbesondere angeordnet am ersten Vakuumbehälter VB1, wo der Betriebsdruck p1 am niedrigsten ist, und einen Temperatursensor 9 für die Erfassung des Meßwertes der Betriebstemperatur t1 des Wassers im Kühlkreislauf 1.1, insbesondere angeordnet nach dem Rohrleitungsaustritt aus dem Belade-Wärmeübertrager 4, wo die Betriebstemperatur t1 am höchsten ist.

Eine Steuer- und Regeleinrichtung 10 regelt unter Verarbeitung der Meßwerte des Drucksensors 8 und des Temperatursensors 9 und unter Verwendung entsprechender interner Druck- und Temperaturregler den Betriebsdruck p1 temperaturabhängig durch Ansteuerung der ersten Vakuumpumpe VP1.

Der Betriebsdruck p1 im Kühlkreislauf 1.1 der Kühlanordnung nach Fig. 1 wird während des Regelbetriebes mittels der Steuer- und Regeleinrichtung 10 in einem Druckbereich mit einem Druck geregelt, der kleiner als der atmosphärische Druck (der mittlere atmosphärische Druck auf Meeresspiegelhöhe beträgt standardmäßig etwa 1013 mbar) und größer als der Sättigungsdampfdruck ps des Wassers ist, welcher der jeweiligen Betriebstemperatur t1 zugehörig ist. Somit wird gewährleistet, dass die Kühlflüssigkeit des Kühlkreislaufes 1.1 trotz subatmosphärischen Druckbedingungen nicht verdampft, also der Kühlkreislauf 1.1 auch regelungstechnisch ein Einphasen-Kühlsystem realisiert.

Druckregelung der Kühlanordnung nach Fig. 1 (subatmosphärische Einphasen-Kühlung):
Mithilfe der gemessenen maximalen Betriebstemperatur t1 des Wassers am Leitungsaustritt des Belade-Wärmeübertrager 4 wird der dazugehörige Sättigungsdampfdruck ps des Wassers ermittelt.

Die zulässige maximale Betriebstemperatur t1 des Wassers nach Austritt aus dem Belade-Wärmeübertrager 4 beträgt bei diesem Ausführungsbeispiel 70°C.

Der zugehörige Sättigungsdampfdruck ps des Wassers beträgt daher:312 mbar.

Der Sättigungsdampfdruck ps zuzüglich eines festgelegten Sicherheitsaufschlages (Δp*) ergibt den zulässigen Minimalwert (p1min) des Betriebsdrucks (p1min = unterer Druckgrenzwert), der an der Stelle der Druckmessung 8 durch die entsprechende Ansteuerung der Vakuumpumpe VP1 mittels der Steuer- und Regeleinrichtung 10 (Vergleich unterer Sollwert - Istwert) eingehalten wird.
p1min = ps + Δp*

Der minimal zulässige Betriebsdruck (pimin, unterer Druckgrenzwert) beträgt bei diesem Ausführungsbeispiel 400 mbar.

Der maximal zulässige Betriebsdruck plmax (oberer Druckgrenzwert) an der Stelle der Druckmessung 8 ergibt sich durch einen weiteren festgelegten Druckwert-Aufschlag (Δp**) des zulässigen Minimaldruckes pimin.
p1max = p1min+Δp**

Der vorgegebene maximale Betriebsdruck plmax ist dabei deutlich tiefer als der Umgebungsdruck eingestellt, und beträgt in diesem Ausführungsbeispiel 500 mbar.

Wird der maximal zulässige Betriebsdruck plmax erreicht oder überschritten (Vergleich oberer Sollwert - Istwert) wird mittels der Steuer- und Regeleinrichtung 10 die erste Vakuumpumpe VP1 automatisch zugeschaltet. Nach Erreichen oder Unterschreiten des minimal zulässigen Druckes p1min wird die Vakuumpumpe VP1 wieder abgeschaltet.

Mittels der Steuer- und Regeleinrichtung 10 können durch diese Druckregelung in dem angegebenen Druckbereich kleinere und mittlere Undichtigkeiten bzw. Lecks, bei denen geringe Mengen an Umgebungsluft eindringen, kompensiert und überwacht werden.

Bei andauerndem Lufteintritt geringen Ausmaßes in den Kühlkreislauf 1.1 kann zur Vermeidung von Wasseraustritt aus der Kühlanordnung die erste Vakuumpumpe VP1 im Dauerbetrieb betrieben sein.

Ein derartiger Betrieb der Kühlanordnung unter dem atmosphärischen Druck ermöglicht bei einer Leckage kleineren Ausmaßes (Leckage-Betrieb) eine temporäre Rückhaltung des Wassers zum Schutz der CPU. Gleichzeitig gewährleistet der Betrieb der Kühlanordnung oberhalb des Sättigungsdampfdruckes eine Vermeidung von Verdampfung oder Teilverdampfung des Wassers, so dass das Wasser im Kühlkreislauf stets nur in einer, fluiden Phase, vorliegt (subatmosphärische Einphasen-Kühlung).

Die Leitungsinstallation 7 des Kühlkreislaufs 1.1 weist weiter einen der Ablauföffnung des ersten Vakuumbehälters VB1 in Strömungsrichtung nachgeordneten Leitungsabzweig 11 auf, dessen Ende mit einem zweiten Vakuumbehälter VB2 verbunden ist. Der Leitungsabzweig 11 umfasst eine vertikal ausgerichtete Steigleitung 12, auch umgangssprachlich als Siphonleitung bezeichnet, in welcher im Regelbetrieb der Kühlanordnung eine druckabhängige Wassersäule steht.

Der zweite Vakuumbehälter VB2 weist eine einzige Anschlussöffnung 13 auf, in der das Ende des Leitungsabzweigs 11 mündet, wobei der zweite Vakuumbehälter VB2 so angeordnet ist, dass sich diese Anschlussöffnung 13 in einer Einbindehöhe H oberhalb des maximalen Füllstands-Niveaus (▼ ^{max}) des ersten Vakuumbehälters VB1 befindet.

Im Regelbetrieb der Kühlanordnung ist der zweite Vakuumbehälter VB2 leer, das heißt, er enthält keinerlei Flüssigkeit.

Der zweite Vakuumbehälter VB2 ist nach diesem Ausführungsbeispiel mit einem Behälterdruck p2 evakuiert ausgebildet.

Der Behälterdruck p2 wird mittels eines weiteren Drucksensors 14 am zweiten Vakuumbehälter VB2 überwacht.

Zur Evakuierung kann über ein nicht dargestelltes Absperrventil des Vakuumbehälters VB2 eine Vakuumpumpe temporär angeschlossen werden, welche das Vakuum mit dem vorbestimmten Behälterdruck p2 einmalig in dem zweiten Vakuumbehälter VB2 erzeugt.

Der Behälterdruck p2 des zweiten Vakuumbehälters VB2 wird kleiner als der kleinste während des Regelbetriebs der Kühlanordnung zu erwartende Betriebsdruck pimin im Kühlkreislauf 1.1 eingestellt (p2 < pimin).

Die Steuer- und Regeleinrichtung 10 kontrolliert mittels des Drucksensors 8 des zweiten Vakuumbehälters VB2 den gewünschten Behälterdruck p2 (Sollwert) .

Entsprechend des voreingestellten Behälterdruckes p2 stellt sich zwischen dem temperaturabhängigen Betriebsdruck p1 im Kühlkreislauf 1.1 und dem zweiten Vakuumbehälter VB2 eine (leicht veränderliche) Druckdifferenz Delta p1 zu p2 (Δp1-2) in der Steigleitung ein, wobei Δp1-2 = p1 - p2 ist), so dass sich in der Steigleitung 12 eine entsprechend (leicht schwankende) Wassersäule mit einem Wasserspiegel oberhalb des Regel-Füllstands-Niveaus ▼ ^{min} des ersten Vakuumbehälters VB1 und unterhalb der Anschlussöffnung 13 des zweiten Vakuumbehälters VB2 ausgebildet. Dadurch ist der zweite Vakuumbehälter VB2 mit einer potentiellen geodätischen Höhe der Wassersäule fluidtechnisch vom Kühlkreislauf 1.1 trennt, ohne jedoch ein Überströmen von Wasser auszulösen.

Die Siphonleitung 12 ist so groß bzw. lang dimensioniert, dass während des Regelbetriebes innerhalb der zulässigen Betriebsdrücke p1 weder ein "Überlaufen" der Flüssigkeit in den zweiten Vakuumbehälter VB2 noch ein "Leersaugen" der Steigleitung 12 durch zu hohen Druck p2 im zweiten Vakuumbehälter VB2 stattfinden kann.

Erhöht sich die Druckdifferenz Δp1-2 erheblich, was insbesondere bei größeren Leckagen im Kühlkreislauf 1.1 durch deutlichen Anstieg des Betriebsdrucks p1 (über plmax) verursacht wird, erreicht die sich daraufhin einstellende größere geodätische Höhe der Wassersäule die Anschlussöffnung 13 des zweiten Vakuumbehälters VB2, so dass das Wasser zwangsläufig und selbsttätig aus dem Kühlkreislauf 1.1 in den zweiten Vakuumbehälter VB2 strömt.

Der zweite Vakuumbehälter VB2 weist in diesem Ausführungsbeispiel einen Fluidspeicherraum 15 auf, der einem unterhalb der Anschlussöffnung 13 ausgebildeten Behälterraum entspricht und ein Fluidspeichervolumen umfasst, das dem gesamten Volumen des im Kühlkreislauf 1.1 enthaltenen Wassers entspricht, so dass der zweite Vakuumbehälter VB2 bei einem größeren Leckage-Fall (Havarie-Fall) das gesamte Wasser aus dem Kühlkreislauf 1.1 aufnehmen kann.

Oberhalb der Anschlussöffnung 13 ist ein Gasspeicherraum 16 mit einem ausreichend großen Gasspeichervolumen ausgebildet, in dem die im Havarie-Fall über das /die Leck(s) nachströmende Luft gesammelt werden kann.

Sowohl während des Druckanstieges im Kühlkreislauf 1.1 als auch nach Einstellen eines Druckausgleichs zwischen dem Druck im Kühlkreislauf 1.1 und dem Umgebungsdruck kann an keiner Stelle der Kühlanordnung Kühlflüssigkeit austreten, da diese sich vollständig in dem ablauflosen zweiten Vakuumbehälter VB2 gesammelt und zu keiner Zeit über dessen Anschlussöffnung 13 zurückströmen kann.

Mit der erfinderischen Kühlanordnung können insbesondere auch größere Lecks im Kühlkreislauf 1.1, bei denen es zu einem erheblichen Druckanstieg im Kühlkreislauf 1.1 kommt, welcher von der geregelten Druckhaltung durch die erste Vakuumpumpe VP1 nicht mehr kompensiert werden kann, sicher bewältigt werden, was eine sehr hohe Betriebssicherheit der Kühlanordnung zum Schutz der Baugruppen und Komponenten der CPU gewährleistet.

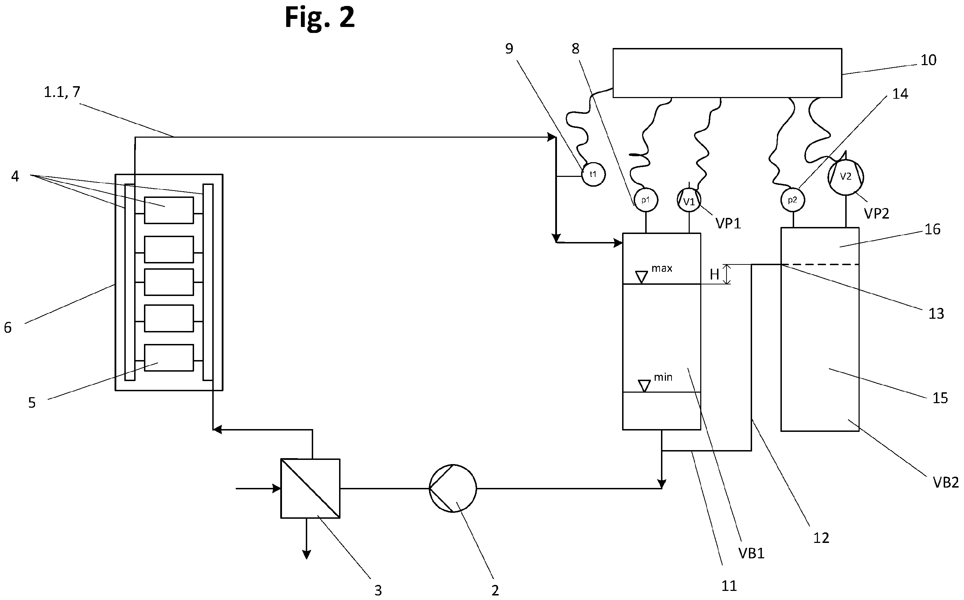

Fig. 2 zeigt ein Schaltbild der erfindungsgemäßen Kühlanordnung nach Fig. 1, wobei im Unterschied zur Ausführung nach Fig. 1 an dem zweiten Vakuumbehälter VB2 eine zweite Vakuumpumpe VP2 angeschlossen ist.

Nachfolgend werden zur Vermeidung von Wiederholungen nur die Unterscheide der Ausführung nach Fig. 2 gegenüber der Ausführung nach Fig. 1 beschrieben. Die hier nicht beschriebenen Merkmale und Funktionsweisen sind mit der vorstehend beschriebenen Ausführung nach Fig. 1 identisch, so dass auf die entsprechende vorstehende Beschreibung verwiesen wird.

Die zweite Vakuumpumpe VP2 dient einerseits zur Evakuierung des zweiten Vakuumbehälter VB2 und zur Differenzdruckhaltung Δp1-2) bzw. Druckhaltung eines konstanten Sollwertes des Behälterdrucks p2 im zweiten Vakuumbehälter VB2 gegenüber dem minimalen Betriebsdruck p1min des ersten Vakuumbehälters VB1.

Andererseits dient die zweite Vakuumpumpe VP2 der Unterstützung der ersten Vakuumpumpe VP1 im Havarie-Modus, wenn größere Undichtigkeiten bzw. Lecks auftreten.

Die zweite Vakuumpumpe VP2 hat eine Pumpenleistung, die größer ist als die Pumpenleistung der ersten Vakuumpumpe VP1.

Die Steuer- und Regeleinrichtung 10, die auch bei dieser Ausführung die vorbeschriebene Druckregelung der Kühlanordnung nach Fig. 1 ausführt, bewirkt bei dieser Ausführung zusätzlich, dass bei Dauerbetrieb der ersten Vakuumpumpe VP2 und Überschreiten des oberen Druckgrenzwertes des Betriebsdruckes (plmax) der Kühlflüssigkeit und folglich mit erheblicher Erhöhung der Druckdifferenz Δp1-2 zwischen erstem und zweitem Vakuumbehälter VB1 zu VB2 die zweite Vakuumpumpe VP2 zugeschaltet wird.

Die erhöhte Druckdifferenz Δp1-2 bewirkt selbsttätig, dass die anschwellende geodätische Höhe der Wassersäule die Anschlussöffnung 13 des zweiten Vakuumbehälters VB2 erreicht, so dass das Wasser zwangsläufig aus dem Kühlkreislauf 1.1 in den zweiten Vakuumbehälter VB2 strömt.

Die beiden Vakuumpumpen VP1 und VP2 arbeiten sodann im Parallelbetrieb, so dass sich deren Pumpenleistungen (Volumenströme) summieren.

Dadurch kann bei plötzlich auftretenden größeren Lecks (Havarie-Fall) in kürzerer Zeit mehr Wasser aus dem Kühlkreislauf 1.1 über die Steigleitung 12 in den zweiten Vakuumbehälter VB2 gesaugt werden.

Gleichzeitig kann mittels der zweiten Vakuumpumpe VP2 die bei der Leckage eingedrungene und mitgeführte Luft aus dem Kühlkreislauf 1.1 schnell abgesaugt werden, so dass der zulässige Betriebsdruck p1 im Kühlkreislauf 1.1 länger gehalten werden kann und damit mehr Zeit verbleibt, um das Wasser vollständig in den zweiten Vakuumbehälter VB2 zu befördern.

Das vorzuhaltende Gasspeichervolumen des zweiten Vakuumbehälters VB2 ist gegenüber der Ausführung nach Fig. 1 geringer, da die Pumpenleistung der zweiten Vakuumpumpe VP2 die aus der Leckage in den zweiten Vakuumbehälter VB2 nachströmende Luft unmittelbar absaugen kann.

Demnach ist der Gasspeicherraum 16 des zweiten Vakuumbehälters VB2 und damit der zweite Vakuumbehälter VB2 an sich kleiner ausgebildet und kann folglich platzsparender angeordnet werden.

Der zu haltende Behälterdruck p2 (Sollwert) wird mittels des Drucksensors 14 kontrolliert und die Vakuumpumpe VP2 mithilfe der Steuer- und Regeleinrichtung 10 entsprechend gesteuert.

Die Druckhaltung des Behälterdruckes p2 im zweiten Vakuumbehälter VB2 kann im Regelbetrieb der Kühlanordnung alternativ auch in Abhängigkeit der temperaturabhängigen Betriebsdruckschwankungen p1 und damit veränderlich nachgeführt sein (p2= p1-Δp1-2), wobei Δp1-2 konstant ist.

Damit ist ein stabiler, im Wesentlichen gleichbleibend hoher Differenzdruck Δp1-2 des Behälterdrucks p2 im zweiten Vakuumbehälter VB2 gegenüber dem Betriebsdruck p1 /p1min des ersten Vakuumbehälters VB1 gehalten, so dass die Rücksaugfunktion der Kühlanordnung im Havarie-Modus mit hoher Intensität zuverlässiger wirksam wird.

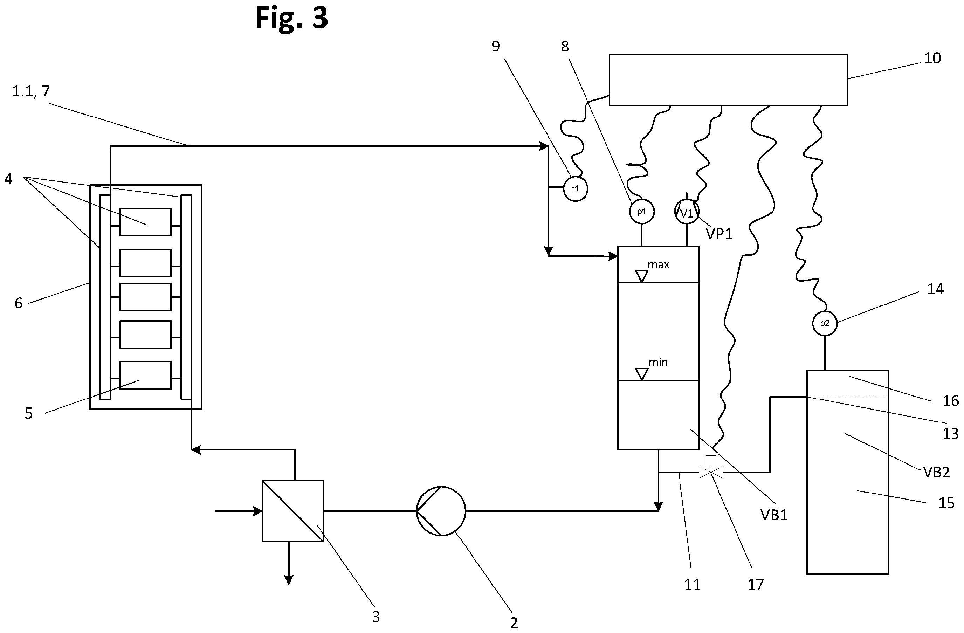

Das Schaltbild nach Fig. 3 zeigt die erfindungsgemäße Kühlanordnung nach Fig. 1 mit einer absperrbaren Siphonleitung.

Nachfolgend werden zur Vermeidung von Wiederholungen nur die Unterscheide der Ausführung nach Fig. 3 gegenüber der Ausführung nach Fig. 1 beschrieben. Die hier nicht beschriebenen Merkmale und Funktionsweisen sind mit der vorstehend beschriebenen Ausführung nach Fig. 1 identisch, so dass auf die entsprechende vorstehende Beschreibung verwiesen wird.

Der Leitungsabzweig 11 weist anstelle einer Steigleitung (Siphonleitung) ein steuerbares Magnetventil als Absperrventil 17 auf, welches von der Steuer- und Regeleinrichtung 10 gesteuert wird.

Im Regelbetrieb der Kühlanordnung, mit einem Betriebsdruck p1 unterhalb des oberen Druckgrenzwertes plmax, bleibt das Magnetventil 17 dauerhaft geschlossen, so dass der Leitungsabzweig 11 gegenüber dem Kühlkreislauf 1.1 mechanisch gesperrt und damit hydraulisch völlig entkoppelt ist.

Der Behälterdruck p2 im zweiten Vakuumbehälter VB2 ist mit einem absoluten Druck, der deutlich unter dem Betriebsdruck p1 des Kühlwasserkreislaufes 1.1 liegen kann (hier zum Beispiel bis nahe 0 bar) evakuiert.

Ist alternativ eine zweite Vakuumpumpe VP2 an dem zweiten Vakuumbehälter angeschlossen (entsprechend der Ausführung nach Fig. 2, hier nicht dargestellt), kann auch diese wie vorstehend zu Fig. 2 beschrieben steuer- bzw. regelbar sein und den niedrigen absoluten Druck p2 geregelt halten.

Steigt der Betriebsdruck p1 im Kühlkreislauf 1.1 trotz Dauerbetrieb der ersten Vakuumpumpe VP1 über den vorgegebenen oberen Druckgrenzwert plmax an, wie das bei einer größeren Leckage (Havarie-Modus) der Fall ist, wird das Magnetventil 17 mittels der Steuer- und Regeleinrichtung 10 geöffnet und das gesamte Wasser des Kühlkreislaufes 1.1 kann selbsttätig und vollständig in den zweiten Vakuumbehälter VB2 strömen.

Mit Erreichen des Druckausgleichs zwischen dem Druck im Kühlkreislauf 1.1 und dem Umgebungsdruckes im Havarie-Fall wird mittels der Steuer- und Regeleinrichtung 10 das Magnetventil 17 unmittelbar wieder geschlossen.

Durch die hydraulische Trennung des zweiten Vakuumbehälters VB2 im Regelbetrieb der Kühlanordnung und beim Erreichen des Druckausgleichs des im Havarie-Fall kann der zweite Vakuumbehälter VB2 unabhängig von der Lage und Länge einer Steigleitung und unabhängig vom maximalen Füllstands-Niveau des ersten Vakuumbehälters VB1 beliebig angeordnet sein.

Durch den sehr niedrigen absoluten Druck im zweiten Vakuumbehälter VB2 steht im Havarie-Modus langfristig eine hohe Druckdifferenz gegenüber dem allmählich ansteigenden Druck im Kühlkreislauf 1.1 zur Verfügung, so dass das Wasser aus dem Kühlkreislauf 1.1 mit großem Rücksaugvolumenstrom noch schneller und sicherer in den zweiten Vakuumbehälter VB2 befördert wird.

Der zweite Vakuumbehälter VB2 nach Fig. 3 weist ein Gasspeicherraum 16 mit einem geringeren vorzuhaltenden Gasspeichervolumen als beim zweiten Vakuumbehälters VB2 nach Fig. 1 oder Fig. 2 auf, da durch den sehr niedrigen absoluten Behälterdruck des zweiten Vakuumbehälters VB2 im Gasspeicherraum 16 eine größere Speicherkapazität für die Speicherung von Leckage-Luft aus dem Kühlkreislauf 1.1 bereitgehalten wird.

Demnach ist der zweite Vakuumbehälter VB2 nach Fig. 3 zudem kleiner als der Vakuumbehälter VB2 nach Fig. 1 oder Fig. 2 ausgebildet und kann folglich noch platzsparender angewandt werden.

Die Kühlanordnung entsprechend der Ausführungsbeispiele nach den Fig. 1 bis 3 ist in der Lage ein größeres Leck mit beispielsweise 5 mm Durchmesser, wie es zum Beispiel beim Ab- oder Aufreißen eines Verbindungsschlauches der Kühlkörper 5 des Belade-Wärmeübertragers 4 im Server 6 auftreten könnte, zu bewältigen, und dabei neben der gesamten Kühlwassermenge des Kühlkreislaufs 1.1 einen durch den Lufteintritt auftretenden (Luft-)Leck-Volumenstrom von bis zu 420 l/min so aufzufangen, dass ein Austreten von Wasser an jeder Stelle der Kühlanordnung und zu jeder Zeit nach Eintreten des Havarie-Falls verhindert wird.

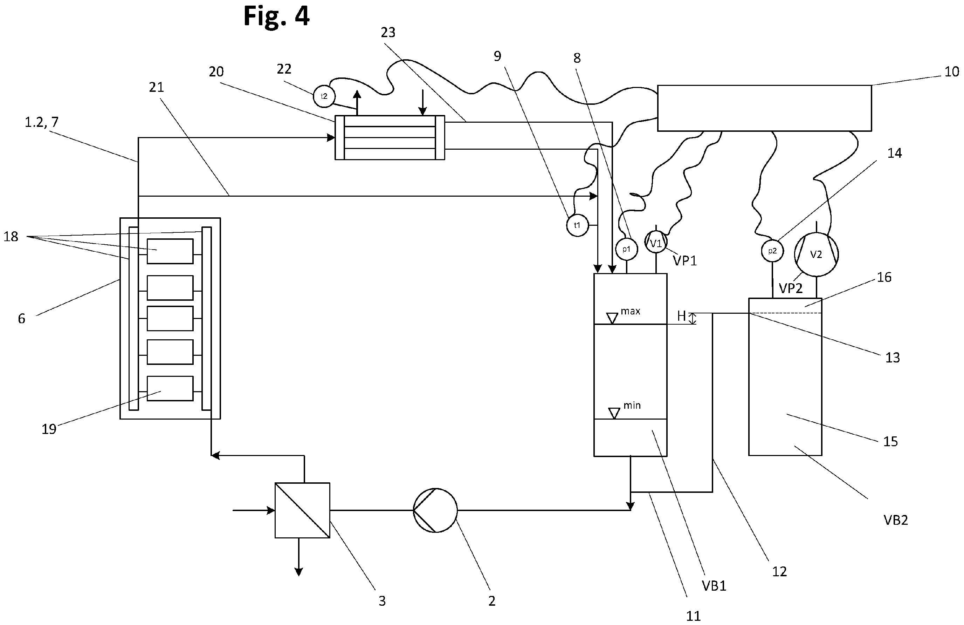

Die alternative Kühlanordnung nach Fig. 4 ist für ein Zweiphasen-Kühlsystem vorgesehen und weist einen Kühlkreislauf 1.2 auf, umfassend die Funktionselemente Umwälzpumpe 2, Entlade-Wärmeübertrager 3, Verdampfer 18 mit den Verdampfer-Kühlkörpern 19, Kondensator 20 und einem ersten Vakuumbehälter VB1 sowie Rohrleitungen einer Leitungsinstallation 7, welche die genannten Funktionselemente 2, 3, 18, 19, 20, VB1 miteinander verbinden.

Der Kühlkreislauf 1.2 enthält Wasser als Kühlmittel, wobei die alternative Kühlanordnung mit Hilfe der genannten Funktionselemente und der unten beschriebenen Betriebsart derart ausgebildet ist, dass sie den Phasenwechsel des Kühlmittels von fluider in gasförmige Phase und umgekehrt nutzen kann, so dass das Kühlmittel im Kühlkreislauf 1.2 der alternativen Kühlanordnung sowohl in fluider als auch in gasförmiger Form Anwendung findet.

Im ersten Vakuumbehälter VB1, in der Umwälzpumpe 2 und in dem Entlade-Wärmeübertrager 3 liegt das Kühlmittel in fluider Phase vor, während im Verdampfer 18 und Kondensator 20 das Kühlmittel zumindest teilweise oder vollständig in gasförmiger Phase vorliegt.

Das Kühlmittel wird mithilfe der Umwälzpumpe 2 in angegebener Pfeilrichtung (Strömungsrichtung) umlaufend durch den Kühlkreislauf 1.2 fördert.

Anstelle des Belade-Wärmeübertragers nach der Ausführung der Kühlanordnung nach Anspruch 1 bis 3, ist bei dieser Ausführung ein Verdampfer 18 vorgesehen, welcher in einem Server 6 angeordnet ist, der mehrere zu kühlende CPUs enthält. Dementsprechend weist der Verdampfer 18 mehrere Verdampfer-Kühlkörper 19 auf, die jeweils an einer CPU des Servers 6 angefügt sind und die durch interne Rohleitungen zwischen einem Verteil-Kanal und einem Sammel-Kanal des Verdampfers parallel geschaltet vom Kühlmittel des Kühlkreislaufes 1.2 durchströmt werden.

Beim Durchströmen der Verdampfer-Kühlkörper 19 wird Betriebswärme aus den anliegenden elektrisch und/oder elektronisch betriebenen Komponenten der CPU (nicht dargestellt) an das fluide Wasser abgegeben, wobei es sich erwärmt und unter den gegebenen Druck im Kühlkreislauf 1.2 zumindest teilweise verdampft, also unter Erwärmung und Verdampfung in den dampf- bzw. gasförmigen Zustand wechselt, wobei das Kühlmittel mit Wärmeenergie aufgeladen wird.

Die Kühlanordnung nach Fig. 4 arbeitet bei einem Betriebsdruck p1, nahe einem bis bei einem der Betriebstemperatur t1 des Kühlmittels zugehörigen Sättigungsdampfdruck ps und damit mit einem deutlich niedrigeren Betriebsdruck p1 als die Kühlanordnung nach den Fig. 1 bis 3, welche als Einphasen-Kühlsystem ausgelegt ist.

Nach der Wärmeaufnahme im Verdampfer 18 strömt der dampfförmige Teil des Kühlmittels zum Kondensator 20, in welchem die dampfförmige Phase des Kühlmittels durch Wärmeübertragung, z.B. mittels eines Gegenstrom-Platten-Wärmeübertragers, an ein externes Wärmeübertragungsmedium, z.B. Wasser, vollständig kondensiert, d.h. in den flüssigen Zustand wechselt.

Der fluid verbliebene Teil des Kühlmittels wird an einem Verteil-T-Stück der Leitungsinstallation 7 abgezweigt und über eine Bypass-Leitung 21 am Kondensator 20 vorbeigeführt und an einem Sammel-T-Stück der Leitungsinstallation 7 mit dem aus dem Kondensator 20 kommenden Kühlmittel wieder zusammengeführt.

Das Wasser in vollständig verflüssigter Phase strömt über eine Zulauföffnung in den ersten Vakuumbehälter VB1, welcher mit einem anteiligen Volumen an Wasser gefüllt und oberhalb eines Füllstands-Niveaus ein Gasvolumen / Gaspolster aufweist.

Zusätzlich kann der Kühlkreislauf 1.2 eine Entlüftungsleitung 23 aufweisen, die - wie in Fig. 4 dargestellt - den Kondensator 20 mit dem Gasraum des ersten Vakuumbehälters VB1 verbindet.

Die Entlüftungsleitung 23 dient vorteilhafter Weise der gesonderten Ableitung von eventuell anfallendem Inertgas aus dem Kondensator 20, so dass der Kondensationsprozess des Wassers nicht behindert und damit effizienter und stabiler erfolgen kann.

Im Regelbetrieb der Kühlanordnung stellt sich ein minimales Füllstands-Niveau (Regel-Füllstands-Niveau) im ersten Vakuumbehälter VB1 ein.

Im Betriebsstillstand der Kühlanordnung, bei ausgeschalteter Umwälzpumpe 2 stellt sich ein maximales Füllstands-Niveau (Ruhe-Füllstands-Niveau) im ersten Vakuumbehälter VB1 ein.

An der Oberseite des ersten Vakuumbehälters VB1 ist die Vakuumpumpe VP1 angeschlossen, mittels der im Kühlkreislauf 1.2 der gewünschte Betriebs-(Unter-)druck, d. h. ein absoluter, subatmosphärischer Druck p1, welcher kleiner als der atmosphärische Druck der Umgebungsluft und beim Sättigungsdampfdruck ps des Wassers bei der herrschenden Betriebstemperatur t1 gelegen ist, erzeugt und gehalten wird (Druckhaltung).

Über eine Ablauföffnung des ersten Vakuumbehälters VB1 wird das Wasser in weiterhin vollständig fluider Phase von der Umwälzpumpe 2 aus dem ersten Vakuumbehälter VB1 angesaugt und dem Entlade-Wärmeübertrager 3 zugeführt.

Im Entlade-Wärmeübertrager 3 wird der restliche Anteil der vom Kühlmittel aus der CPU aufgenommenen Wärme, z.B. mittels eines Gegenstrom-Platten-Wärmeübertragers, an ein externes Wärmeübertragungsmedium, hier z.B. Wasser, übertragen, wobei sich das Kühlmittel weiter abgekühlt, also restlich von der aufgenommenen Wärmeenergie "entladen" wird.

Das gekühlte Wasser wird weiter in flüssiger Phase zum Verdampfer 18 gefördert um wiederholt und dauerhaft Betriebswärme aus den CPUs aufzunehmen.

Die Kühlanordnung weist des Weiteren einen Drucksensor 8 für die Erfassung des Meßwertes des Betriebsdrucks (absoluter Druck) p1 im Kühlkreislauf 1.2, insbesondere angeordnet am ersten Vakuumbehälter VB1, wo der Betriebsdruck p1 am niedrigsten ist, und ein Temperatursensor 9 für die Erfassung des Meßwertes der Betriebstemperatur t1 des Wassers im Kühlkreislauf 1.2, insbesondere angeordnet nach dem Sammel-T-Stück der Leitungsinstallation 7.

Die Steuer- und Regeleinrichtung 10 regelt unter Verarbeitung der Meßwerte des Drucksensors 8, des Temperatursensors 9 und ggf. zusätzlich unter Verarbeitung der Meßwerte des Temperatursensors 22 den Betriebsdruck p1 temperaturabhängig durch Ansteuerung der ersten Vakuumpumpe VP1.

Der Betriebsdruck p1 im Kühlkreislauf 1.2 der Kühlanordnung nach Fig. 4 wird während des Regelbetriebes mittels der Steuer- und Regeleinrichtung 10 in einem Druckbereich mit einem Druck geregelt, der sehr viel kleiner als der atmosphärische Druck ist und nahe dem Sättigungsdampfdruck ps des Wassers liegt oder dem Sättigungsdampfdruck ps des Wassers entspricht, welcher der jeweiligen Betriebstemperatur t1 zugehörig ist.

Druckregelung der Kühlanordnung nach Fig. 4 (subatmosphärische Zweiphasen-Kühlung):
Der Kühlkreislauf 1.2 wird mittels der ersten Vakuumpumpe VP1 zunächst bis zu dem Sättigungsdampfdruck ps evakuiert, der abhängig von der aktuellen tatsächlichen Temperatur t1 des Kühlmittels ist.

Während des Regelbetriebs der Kühlanordnung erwärmt sich das Kühlmittel im Verdampfer 18 und verdampft zumindest teilweise durch die Wärmeaufnahme von den CPUs, und wird anschließend im Kondensator 20 wieder gekühlt und verflüssigt.

Die Kondensations- und Rückkühlbedingungen im Kondensator 20, welche u. a. durch die Kühlleistung des externen Wärmeübertragermediums des Kondensators 20 und durch einen eventuell bereits enthaltenen minimalen Luftanteil (Inertgas) im Kühlkreislauf 1.2 bestimmt sind, bewirken einen bestimmten Kondensationsdruck bei der Kondensation des Wassers, der den Betriebsdruck p1 bestimmt, der am nachgeordneten Vakuumbehälter mittels des Drucksensors 8 messbar ist. Die sich aus der Kondensation ergebende Kondensationstemperatur ist mittels des Temperatursensors 9 als Austrittstemperatur t1 des Wassers aus dem Kondensator 20 messbar und als die Betriebstemperatur t1 im Regelbetrieb bestimmt, auch wenn sich am Austritt des Verdampfers 18 infolge von Druckverlusten im Kühlkreislauf 1.2 zwischen Verdampfer 18 und dem Messpunkt t1 eine etwas höhere Verdampfungstemperatur einstellt.

Mit Hilfe der am Austritt des Kondensators 20 gemessenen Betriebstemperatur t1 wird der dazugehörige Sättigungsdampfdruck ps ermittelt. Bei einer Betriebstemperatur t1 von 70 °C beträgt der Sättigungsdampfdruck von Wasser 312 mbar.

Der Sättigungsdampfdruck ps zuzüglich eines festgelegten Druckwert-Aufschlages von Δp**(z. B. 50 mbar) ergibt den maximal zulässigen Betriebsdruck plmax (plmax = oberer Druckgrenzwert).

Überschreitet der mithilfe des Drucksensors 8 gemessene Betriebsdruck p1 diesen oberen Druckgrenzwert plmax, erfolgt die Zuschaltung der Vakuumpumpe VP1 mittels der Steuer- und Regeleinrichtung 10.

Mit anderen Worten, wenn p1 > p1max = ps + Δp** ist (in diesem Ausführungsbeispiel p1 > (312 + 50) mbar), wird die Vakuumpumpe VP1 eingeschaltet.

Die Vakuumpumpe VP1 wird mittels der Steuer- und Regeleinrichtung 10 wieder abgeschaltet, wenn der gemessene Druck p1 den minimal zulässigen Betriebsdruck (p1min = unterer Druckgrenzwert) unterschreitet. Dieser untere Druckgrenzwert bestimmt sich aus dem Sättigungsdampfdruck ps zuzüglich eines festgelegten Sicherheitsaufschlages von Δp* (z.B. 30 mbar) unterschreitet.

Mit anderen Worten, wenn p1 < p1min = ps + Δp* ist (in diesem Ausführungsbeispiel p1< (312 + 30) mbar), wird die Vakuumpumpe VP1 mittels der Steuer- und Regeleinrichtung 10 abgeschaltet.

Mittels der Steuer- und Regeleinrichtung 10 können durch diese Druckregelung in dem angegebenen Druckbereich kleinere und mittlere Undichtigkeiten bzw. Lecks, bei denen geringe Mengen an Umgebungsluft eindringen, kompensiert und überwacht werden und damit eine temporäre Rückhaltung des Wassers zum Schutz der CPU gewährleistet werden (Leckage-Betrieb analog der Druckregelung nach Fig. 1 bis 3).

Zusätzlich kann bei der Kühlanordnung für das Zweiphasen-Kühlsystem nach Fig. 4 zur Unterstützung der vorbeschriebenen Druckreglung folgende temperaturgeführte Druckregelung vorgesehen werden, da der Betriebsdruck p1 auch abhängig ist von der Inertgaskonzentration im Kondensator 20 und der Austrittstemperatur t2 des externen Wärmeübertragermediums am Kondensator 20, welche mit dem Temperatursensor 22 messbar ist.

Ein im Kühlkreislauf 1.2 durch kleinere Lecks bereits enthaltene oder sukzessive eintretende Luft (Inertgas) sammelt sich als erstes am geodätisch höchsten Punkt des Kühlkreislaufes 1.2, an welchem gewöhnlich der Kondensator 20 angeordnet ist und kann somit die Inertgaskonzentration im Kondensator 20 erhöhen.

Unter der idealen Bedingung, wenn noch keine Luft durch Lecks in den Kühlkreislauf 1.2 eingedrungen ist, also bei einer Inertgaskonzentration von 0 % im Kondensator 20 und der maximal abführbaren Leistung im Kondensator 20 ist die Temperaturdifferenz ΔtK, als Differenz zwischen der Austrittstemperatur t1 des Kühlmittels aus dem Kondensator 20 und der Austrittstemperatur t2 des externen Wärmeübertragermediums aus dem Kondensator 20 (ΔtK = t1 - t2), bekannt. Diese Temperaturdifferenz ΔtK kann zum Beispiel bei 5 K liegen und ist als idealer Sollwert ΔtKₛₒₗₗ vorgegeben.

Durch Eindringen bereits geringer Mengen an Luft und damit einer Erhöhung der Inertgaskonzentration im Kondensator 20 wird der Kondensationsprozess zunehmend behindert, was sich durch unerwünschte Erhöhung der Temperaturdifferenz ΔtK zwischen der gemessenen Austrittstemperatur t1 des Kühlmittels aus dem Kondensator 20 und der gemessenen Austrittstemperatur t2 des externen Wärmeübertragermediums aus dem Kondensator 20 ausdrückt, wobei sich beispielsweise bei gleichbleibender Austrittstemperatur t2 des externen Wärmeübertragermediums die Austrittstemperatur t1 des Kühlmittels aus dem Kondensator 20 und damit die Betriebstemperatur t1 erhöht. Mit steigender Betriebstemperatur t1 steigt folglich auch der Betriebsdruck p1 im Kühlkreislauf 1.2 an.

Zur zusätzlichen Regelung des Betriebsdrucks p1 im Kühlkreislauf 1.2 mittels der temperaturgeführten Druckregelung wird die erste Vakuumpumpe VP1 am ersten Vakuumbehälter VB1 eingeschaltet, wenn die aktuell gemessene Temperaturdifferenz ΔtKᵢₛₜ einen als noch zulässig bestimmten Maximalwert ΔtKₘₐₓ überschreitet, der durch einen festgelegten Temperatur-Aufschlag Δt** über dem Sollwert ΔtKₛₒₗₗ bestimmt ist (ΔtKᵢₛₜ > ΔtKₘₐₓ = ΔtKₛₒₗₗ.+ Δt**) . Beispielsweise beträgt der Temperatur-Aufschlag Δt** in diesem Ausführungsbeispiel 2 K) .

Die erste Vakuumpumpe VP1 wird wieder abgeschaltet, wenn die aktuell gemessene Temperaturdifferenz ΔtKᵢₛₜ einen bestimmten Minimalwert ΔtKₘᵢₙ unterschreitet, der durch einen festgelegten Sicherheitszuschlag Δt* über dem Sollwert ΔtKₛₒₗₗ bestimmt ist, wobei der Sicherheitszuschlag Δt* stets kleiner als der Temperatur-Aufschlag Δt** ist (ΔtKᵢₛₜ < ΔtKₘᵢₙ = ΔtKₛₒₗₗ.+ Δt*) . Beispielsweise beträgt der Sicherheitszuschlag Δt* in diesem Ausführungsbeispiel 1 K).

Somit kann durch diese zusätzliche periodische Schaltung der ersten Vakuumpumpe VP1 die Kühlanordnung im Zweiphasenkühlsystem bei zunächst geringen Leckvolumenströmen eindringender Luft noch zuverlässiger und sicherer betrieben werden.

Bei andauerndem Lufteintritt geringen Ausmaßes in den Kühlkreislauf 1.2 kann zur Vermeidung von Wasseraustritt aus der Kühlanordnung die erste Vakuumpumpe VP1 im Dauerbetrieb betrieben sein.

Die Ausführung und Anbindung des zweiten Vakuumbehälters VB2 mittels einem an den Kühlkreislauf 1.2 angebundenen Leitungsabzweig 11 mit Steigleitung 12(Siphonleitung) und deren Funktionsweise mit Hilfe einer am Ende des Leitungsabzweigs 11 angeschlossenen zweiten Vakuumpumpe VP2 ist analog dem Ausführungsbeispiel nach Fig. 1 bzw. 2 ausgebildet, weshalb zur Vermeidung von Wiederholungen auf die diesbezüglichen, vorstehenden Ausführungen zu Fig. 1 und 2 verwiesen wird.

Die zweite, größere Vakuumpumpe VP2 dient neben der Evakuierung des zweiten Vakuumbehälters VB2 zur Differenzdruckhaltung Δp1-2 des Behälterdrucks p2 im zweiten Vakuumbehälter VB2 gegenüber dem Betriebsdruck p1 des Kühlmittels bei der herrschenden Betriebstemperatur t1 im ersten Vakuumbehälter VB1.

Im zweiten Vakuumbehälter VP2 herrscht demnach ein sehr niedriger absoluter Behälterdruck p2, der beispielweise 25 mbar unter dem Betriebsdruck p1 liegt. Bei einem Betriebsdruck p1 von 342 mbar ergibt sich ein absoluter Druck p2 im Vakuumbehälter VB2 von 317 mbar.

Die Druckhaltung des Behälterdruckes p2 im zweiten Vakuumbehälters VB2 ist im Regelbetrieb der Kühlanordnung analog der zu Fig. 2 beschriebenen Druckhaltungsvarianten vorgesehen.

Die Steuer- und Regeleinrichtung 10 bewirkt auch bei dieser Ausführung, dass im Havarie-Fall, also bei Dauerbetrieb der ersten Vakuumpumpe VP1 und Überschreiten des oberen Druckgrenzwertes des Betriebsdruckes des Kühlmittels (plmax) und damit bei erheblicher Erhöhung der Druckdifferenz Δp1-2 die zweite Vakuumpumpe VP2 im Parallelbetrieb zugeschaltet wird.

Die erhöhte Druckdifferenz Δp1-2 bewirkt zudem selbsttätig, dass die anschwellende geodätische Höhe der Wassersäule die Anschlussöffnung 13 des zweiten Vakuumbehälters VB2 erreicht, so dass das Wasser zwangsläufig und sehr schnell aus dem Kühlkreislauf 1.2 in den zweiten Vakuumbehälter VP2 strömt.

Infolge der stabilen, im Wesentlichen gleichbleibend hohen Differenzdruck Δp1-2 bei zugleich sehr niedrigem Behälterdruck p2 im zweiten Vakuumbehälter VB2 gegenüber dem Betriebsdruck p1 im ersten Vakuumbehälter VB1 bzw. im Kühlkreislauf 1.2 wird die Rücksaugfunktion der Kühlanordnung im Havarie-Modus mit besonders hoher Intensität zuverlässig ausgeführt.

Es kann mit der Kühlanordnung nach Fig. 4 im Prinzip der Zweiphasen-Kühlung die erforderliche Wärmemenge aus den elektrisch und/oder elektronisch betriebenen Komponenten der CPU bei geringerem Massenstrom des im Kühlkreislauf 1.2 umlaufenden Kühlmittels im Vergleich zum umlaufenden Kühlwasser bei der Kühlanordnung nach Fig. 1 bis 3 aufgenommen und abgeführt werden und damit die Pumpenleistung der Umwälzpumpe 2 und im Weiteren das für den Leckage-Fall vorzuhaltende Fluidspeichervolumen im Fluidspeicherraum 15 des zweiten Vakuumbehälters VB2 verringert werden.

Zusätzlich wird durch den sehr niedrigen absoluten Druck des zweiten Vakuumbehälters VB2 eine größere Speicherkapazität im Gasspeicherraum 16 für die Speicherung der Leckage-Luft aus dem Kühlkreislauf 1.2 bereitgestellt, womit das für den Leckage-Fall vorzuhaltende Gasspeichervolumen im zweiten Vakuumbehälter VB2 verringert werden kann.

Der zweite Vakuumbehälter VB2 ist damit mit jeweils einem geringeren Fluidspeicherraum 15 und geringerem Gasspeicherraum 16 gegenüber dem Fluidspeicherraum 15 und Gasspeicherraum 16 der Kühlanordnungen nach den Fig. 1 bis 3 ausgebildet, so dass der gesamte zweite Vakuumbehälter VB2 umso kleiner gestaltet ist.

Die Ausführung der Kühlanordnung nach Fig. 4 kann beispielsweise auch in Kombination mit einem einmalig evakuierten zweiten Vakuumbehälter VB2 analog der Ausführung nach Fig. 1 und/oder in Kombination mit einem durch ein Absperrventil 17 absperrbaren Leitungsabzweig 11 nach Fig. 3 ausgebildet sein.

Der Schutzumfang der vorliegenden Erfindung wird durch die angefügten Ansprüche und unter Einbeziehung der gesamten Beschreibung und der Figuren definiert.

### Bezugszeichenliste

- 1: Kühlkreislauf .1 für ein Einphasen-Kühlsystem, .2 für ein Zweiphasen-Kühlsystem
- 2: Umwälzpumpe
- 3: Entlade-Wärmeübertrager
- 4: Belade-Wärmeübertrager
- 5: Kühlkörper des Belade-Wärmeübertragers, angeordnet an je einer CPU
- 6: Server
- 7: Rohrleitung, Leitungsinstallation
- 8: Drucksensor
- 9: Temperatursensor
- 10: Steuer- und Regeleinrichtung
- 11: Leitungsabzweig
- 12: Steigleitung
- 13: Anschlussöffnung des zweiten Vakuumbehälters
- 14: Drucksensor
- 15: Fluidspeicherraum des zweiten Vakuumbehälters
- 16: Gasspeicherraum des zweiten Vakuumbehälters
- 17: Absperrventil, Magnetventil
- 18: Verdampfer
- 19: Kühlkörper des Verdampfers, Verdampfer-Kühlkörper, angeordnet an je einer CPU
- 20: Kondensator
- 21: Bypass-Leitung
- 22: Temperatursensor
- 23: Entlüftungsleitung
- VB1: erster Vakuumbehälter
- VB2: zweiter Vakuumbehälter
- ▼ ^{min}: minimales Füllstands-Niveau (Regel-Füllstands-Niveau)
- ▼ ^{max}: maximales Füllstands-Niveau (Ruhe-Füllstands-Niveau)
- VP1: erste Vakuumpumpe
- VP2: zweite Vakuumpumpe
- p1: Betriebsdruck im Kühlkreislauf
- pimin: unterer Druckgrenzwert
- plmax: oberer Druckgrenzwert
- p2: Behälterdruck im zweiten Vakuumbehälter
- t1: Betriebstemperatur im Kühlkreislauf
- t2: Temperatur des externen Wärmeübertragermediums am Austritt aus dem Kondensator
- ps: Sättigungsdampfdruck der Kühlflüssigkeit / des Kühlmittels
- H: Einbindehöhe der Anschlussöffnung des zweiten Vakuumbehälters

## Patentansprüche

1. Kühlanordnung zum Kühlen und Abführen der Betriebswärme von elektrisch und/oder elektronisch betriebenen Komponenten oder Baugruppen dieser Komponenten eines Computersystems, aufweisend:
- a) eine umlaufend ausgebildete Leitungsinstallation (7), welche in Verbindung mit den nachfolgend angeführten Funktionselementen einen Kühlkreislauf (1.1) bildet, welcher eine Kühlflüssigkeit, vorzugsweise Wasser, als Kühlmedium enthält:
- aa) mit wenigstens einer Umwälzpumpe (2) zur umlaufenden Förderung der Kühlflüssigkeit im Kühlkreislauf (1.1) während des Betriebs der Kühlanordnung,
- ab) mit wenigstens einem Belade-Wärmeübertrager (4) zur Übertragung von Betriebswärme aus dem Computersystem an die Kühlflüssigkeit,
- ac) mit wenigstens einem Entlade-Wärmeübertrager (3) zur Übertragung der von der Kühlflüssigkeit aus dem Computersystem aufgenommenen Wärme an ein externes Wärmeübertragungsmedium und
- ad) mit einem ersten Vakuumbehälter (VB1), der zumindest über eine Zu- und eine Ablauföffnung mit dem Kühlkreislauf (1.1) verbunden ist und bis zu einem maximalen Füllstands-Niveau mit der Kühlflüssigkeit befüllbar ist, und
- ae) mit einer ersten Vakuumpumpe (VP1), die im Betrieb der Kühlanordnung einen Betriebsdruck (p1) der Kühlflüssigkeit im Kühlkreislauf (1.1) erzeugt, der kleiner als der atmosphärische Druck und größer als der Sättigungsdampfdruck ps der Kühlflüssigkeit ist,
- b) die Kühlanordnung weiter aufweisend einen an dem Kühlkreislauf (1.1) angeschlossenen Leitungsabzweig (11)
ba) mit einer Steigleitung (12), in welcher eine Flüssigkeitssäule der Kühlflüssigkeit ausgebildet ist, oder
bb) mit einem steuerbaren Absperrventil (17),
- c) die Kühlanordnung weiter aufweisend einen zweiten Vakuumbehälter (VB2), welcher mit dem einzigen Ende des Leitungsabzweiges (11) verbunden ist, wobei dessen Behälterdruck (p2) zumindest gleich groß, vorzugsweise kleiner als der Betriebsdruck p1 im Kühlkreislauf (1.1) ist.

2. Kühlanordnung zum Kühlen und Abführen der Betriebswärme von elektrisch und/oder elektronisch betriebenen Komponenten oder Baugruppen dieser Komponenten eines Computersystems, aufweisend:
- a) eine umlaufend ausgebildete Leitungsinstallation (7), welche in Verbindung mit den nachfolgend angeführten Funktionselementen einen Kühlkreislauf (1.2) bildet, welcher ein Kühlmittel in fluider und gasförmiger Phase als Kühlmedium enthält:
- aa) mit wenigstens einer Umwälzpumpe (2) zur umlaufenden Förderung des Kühlmittels im Kühlkreislauf (1.2) während des Betriebs der Kühlanordnung,
- ab) mit wenigstens einem Entlade-Wärmeübertrager (3) zur Übertragung der vom Kühlmittel aus dem Computersystem aufgenommenen Wärme an ein externes Wärmeübertragungsmedium,
- ac) mit wenigstens einem Verdampfer (18) zur mindestens teilweisen Verdampfung des Kühlmittels und Übertragung von Betriebswärme aus dem Computersystem an das Kühlmittel,
- ad) mit wenigstens einem Kondensator (20) zur Kondensierung des dampfförmigen Teils des Kühlmittels und zur Übertragung der vom Kühlmittel aus dem Computersystem aufgenommenen Wärme an ein externes Wärmeübertragungsmedium,
- ae) mit einem ersten Vakuumbehälter (VB1), der zumindest über eine Zu- und eine Ablauföffnung mit dem Kühlkreislauf (1.2) verbunden ist und bis zu einem maximalen Füllstands-Niveau mit dem Kühlmittel befüllbar ist,
- af) mit einer ersten Vakuumpumpe (VP1), die im Betrieb der Kühlanordnung (1.2) einen Betriebsdruck (p1) des Kühlmittels im Kühlkreislauf (1.2) erzeugt, der kleiner als der atmosphärische Druck ist und dem Sättigungsdampfdruck (p2) des Kühlmittels entspricht.
- b) die Kühlanordnung weiter aufweisend einen an dem Kühlkreislauf (1.2) angeschlossenen Leitungsabzweig (11)
- ba) mit einer Steigleitung (12), in welcher eine Flüssigkeitssäule des Kühlmittels ausgebildet ist, oder
- bb) mit einem steuerbaren Absperrventil (17),
- c) die Kühlanordnung weiter aufweisend einen zweiten Vakuumbehälter (VB2), welcher mit dem einzigen Ende des Leitungsabzweiges (11) verbunden ist, wobei dessen Behälterdruck (p2) zumindest gleich groß, vorzugsweise kleiner als der Betriebsdruck (p1) im Kühlkreislauf (1.2) ist.

3. Kühlanordnung nach Anspruch 1 oder 2, **dadurch gekennzeichnet, dass** der zweite Vakuumbehälter (VB2) oberhalb der in der Steigleitung (12) ausgebildeten Flüssigkeitssäule des Kühlmediums mit dem Leitungsabzweig (11) verbunden ist.

4. Kühlanordnung nach einem der vorstehenden Ansprüche 1 bis 3, **dadurch gekennzeichnet, dass** der zweite Vakuumbehälter (VB2) derart in Bezug zum ersten Vakuumbehälter (VB1) angeordnet ist, dass der Leitungsabzweig (11) in einer Einbindehöhe H oberhalb des maximalen Füllstands-Niveaus des Kühlmediums des ersten Vakuumbehälters (VB1) in den zweiten Vakuumbehälter (VB2) mündet.

5. Kühlanordnung nach einem der vorstehenden Ansprüche 1 bis 4, **dadurch gekennzeichnet, dass** der zweite Vakuumbehälter (VB2) einen Fluidspeicherraum (15) aufweist, dessen Fluidspeichervolumen mindestens dem Gesamtvolumen des im Kühlkreislauf (1.1) enthaltenen Kühlmediums entspricht.

6. Kühlanordnung nach einem der vorstehenden Ansprüche 1 bis 5, **dadurch gekennzeichnet, dass** der zweite Vakuumbehälter (VB2) einen Gasspeicherraum (16) aufweist.

7. Kühlanordnung nach einem der vorstehenden Ansprüche 1 bis 6, **gekennzeichnet, durch** eine Steuer- und Regeleinrichtung (10), welche den Betriebsdruck (p1) des Kühlmediums zwischen einem unteren und oberen Druckgrenzwert (p1min, p1max) regelt.

8. Kühlanordnung nach einem der vorstehenden Ansprüche 1 bis 7, **dadurch gekennzeichnet, dass** an dem zweiten Vakuumbehälter (VB2) eine zweite Vakuumpumpe (VP2) angeschlossen ist.

9. Kühlanordnung nach Anspruch 8, **dadurch gekennzeichnet, dass** die Steuer- und Regeleinrichtung (10) derart ausgebildet ist, dass bei Überschreiten des oberen Druckgrenzwertes (plmax) des Betriebsdruckes (p1) des Kühlmediums die zweite Vakuumpumpe (VP2) zugeschaltet wird.

10. Kühlanordnung nach einem der vorstehenden Ansprüche 7 bis 9, **dadurch gekennzeichnet, dass** die Steuer- und Regeleinrichtung (10) derart zur Steuerung des Absperrventils (17) ausgebildet ist, dass das Absperrventil (17) bei Überschreiten des oberen Druckgrenzwertes (plmax) des Betriebsdruckes (p1) des Kühlmediums geöffnet wird.

11. Kühlanordnung nach einem der vorstehenden Ansprüche 1 bis 10, **dadurch gekennzeichnet, dass** die Pumpenleistung der zweiten Vakuumpumpe (VP2) größer als die Pumpenleistung der ersten Vakuumpumpe (VP1) ausgebildet ist.

12. Verfahren zum Kühlen und Abführen der Betriebswärme von elektrisch und/oder elektronisch betriebenen Komponenten oder Baugruppen dieser Komponenten eines Computersystems, mittels einer Kühlanordnung mit den Merkmalen nach einem der Ansprüche 1 bis 11.
